Europäisches Patentamt
European Patent Office
Office européen des brevets

(19)

(11) Publication number: **0 340 968 A2**

# (12) EUROPEAN PATENT APPLICATION

(21) Application number: 89304234.1

(22) Date of filing: 27.04.89

(51) Int. Cl.⁴: G03C 1/733 , G03C 7/12 , G02F 1/133 , G02F 1/35 , G11B 7/24 , G03G 5/09

(30) Priority: 30.04.88 JP 108726/88
12.07.88 JP 174102/88
13.07.88 JP 175610/88
28.07.88 JP 189201/88
28.07.88 JP 189202/88
06.10.88 JP 252524/88
07.10.88 JP 253043/88
13.10.88 JP 257819/88
25.10.88 JP 268507/88
18.11.88 JP 291497/88
09.11.88 JP 283418/88
26.11.88 JP 299039/88
11.01.89 JP 4038/89
31.01.89 JP 21505/89
31.01.89 JP 21509/89

(43) Date of publication of application: 08.11.89 Bulletin 89/45

(84) Designated Contracting States: CH DE FR GB LI

(71) Applicant: SEIKO EPSON CORPORATION
4-1, Nishishinjuku 2-chome
Shinjuku-ku Tokyo-to(JP)

(72) Inventor: Matsushima, Fumiaki
c/o Seiko Epson Corporation 3-5 Owa
3-chome
Suwa-shi Nagano-ken(JP)
Inventor: Atobe, Mitsuro
c/o Seiko Epson Corporation 3-5 Owa
3-chome
Suwa-shi Nagano-ken(JP)
Inventor: Ono, Yoshihiro
c/o Seiko Epson Corporation 3-5 Owa
3-chome
Suwa-shi Nagano-ken(JP)
Inventor: Nose, Yasuto
c/o Seiko Epson Corporation 3-5 Owa
3-chome
Suwa-shi Nagano-ken(JP)

(74) Representative: Caro, William Egerton et al
J. MILLER & CO. Lincoln House 296-302 High Holborn
London WC1V 7JH(GB)

## (54) Thin film device and method of manufacturing the same.

(57) A thin film device is produced by electrolysis in a solution containing an organic material, an inorganic material or a material being a mixture thereof which material is sparingly soluble or insoluble in water and a surfactant for solubilising said organic material, inorganic material or mixture thereof.

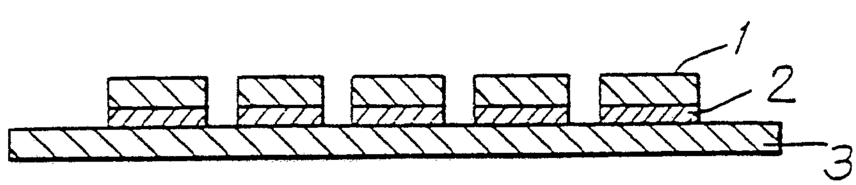


FIG. 1

EP 0 340 968 A2

# THIN FILM DEVICE AND METHOD OF MANUFACTURING THE SAME

The present invention relates to thin film devices and methods of manufacturing the same. More particularly, although not so restricted, the present invention relates to a thin film device produced by solubilising a substance which is sparingly soluble or insoluble in water in a micelle solution of a surfactant and depositing the substance on an electrode by an electro-chemical method, and to a method of manufacturing such a thin film device.

Organic pigments such as phthalocyanine have recently attracted much attention as functional materials. This is because the characteristic structures of such organic pigments exhibit interesting characteristics as photo-conductors or optical devices.

Since such organic pigments are generally sparingly soluble or insoluble in water, a wet process is rarely adopted for producing thin films. Some attempts have been made at converting an organic pigment to a solvent-soluble pigment and forming a thin film by a dipping method or the like, but this only enables an ultra thin film having very restricted applications to be produced. Adaptation of a Langmuir Blodgett technique also has a similar problem. In some cases, the fine particles of an organic pigment are kneaded with an organic binder and thinly coated to form a functional film. However, there is the drawback that the function is not fully displayed due to the existence of the binder.

Accordingly, a thin film is generally formed by deposition, sputtering or CVD, but these methods have also drawbacks. For example, when a thin film is formed, the chemical structure of the thin film disadvantageously either is different from that of the starting material or the reproduction of the initial crystalline structure is often impossible in spite of the same chemical structure. In addition, a vacuum method is disadvantageous in terms of the cost of mass production.

A technique for solving such problems has recently been proposed by Saji et al (Chem. Lett., 1431, (1987), J. am. Chem. Soc., 109, 5881 (1987),. Chem. Lett., 893 (1988), Synopses of Lectures of 55th Meeting of the Electrochemical Society of Japan). This a method of forming a thin film by solubilising a pigment or a polymer which is hydrophobic in an aqueous micelle of an oxidisable and reducible surfactant consisting of a ferrocene derivative in an aqueous medium, and depositing the solubilized pigment or polymer on an electrode by electro-analysis. In the present state of art, however, the surfactants and the substances usable in this method are restricted within narrow limits.

According to one aspect of the present invention there is provided thin film device produced by electrolysis in a solution characterised by containing an organic material, an inorganic material or a material being a mixture thereof which material is sparingly soluble or insoluble in water and a surfactant for solubilising said organic material, inorganic material or mixture thereof.

Said organic material may be an organic pigment and may be selected from the group mainly consisting of phthalocyanine pigment, anthraquinone pigment, thioindigo pigment, perylene pigment, quinacridone pigment, dioxazine pigment, isoindolinone pigment, quinophthalone pigment, perinone pigment, nitro pigment, nitroso pigment, azo complex salt pigment, condensed azo pigment, benzoimidazolone pigment, metal complex pigment, aniline black, daylight fluorescent pigment and diketopyrrolopyrrole pigment.

Said inorganic material may be a hydrophilic substance with the surface nature thereof converted into a hydrophobic nature.

Said surfactant preferably has a metallocene group represented by the following general formula as a hydrophobic end group:

$[M(C_2H_5)_2]$

wherein M represents Cr, Ti, Fe, V, Co, Ni, Ru, Is, Pd or the like.

Said organic material or inorganic material may be particulate having a primary particle diameter of 0.005 to 0.5 µm.

Said thin film device may contains a dopant e.g. a halogen for providing electrical conductivity. Said halogen may be doped by dissolving a halogen or a halogen compound in said aqueous micelle solution so as to deposit said halogen together with a film material. Said halogen is doped by immersing said thin film device in a solution containing a halogen or a halogen compound after the formation of said thin film device so as to effect electrolysis.

In one embodiment said thin film device is used for a colour filter.

Each coloured layer of said colour filter each composed of a mixture of at least two types of organic pigments.

An insulating film or a high-resistance film may be formed on a part of the unselected electrode pattern in advance when electrolysis is carried out by selectively establishing electric conduction on a specific

electrode pattern formed on a substrate.

A light-shielding film may be formed between the transparent electrode patterns formed on a transparent substrate. Said light-shielding film may be formed by a dyeing method using photo-lithography.

Said light-shielding film may be a photo-setting type photo-sensitive resin containing a pigment.

Alternatively said light-shielding film may be formed by a method comprising the steps of plating a metal film on the transparent electrode formed into a predetermined pattern on a transparent substrate in advance, coating said metal film with a negative resist containing a light-shielding material, exposing the opposite side of said transparent substrate to the coated side to UV light and developing said transparent substrate so as to form said light-shielding film between said transparent electrode patterns.

Said light-shielding pattern may be formed by printing between the patterns with coloured layers formed thereon or on the opposing substrate at the portions facing the gaps between said patterns with said coloured layers formed thereon.

In another embodiment said thin film device is used for an optical recording medium.

A photo-chromic film may be formed. Alternatively, a thin film of a compound having a photo-chemical hole burning effect may be formed.

In a further embodiment said thin film device is used for an electro-photographic photo-receptor. Said thin film device may be used as a carrier generating layer of said electro-photographic photo-receptor.

According to another aspect of the present invention there is provided a method of manufacturing a thin film device comprising the steps of solubilising an organic material, an inorganic material or a mixture thereof which is sparingly soluble or insoluble in water in an aqueous micelle solution of a surfactant which is charged by electrolysis, and carrying out electrolysis in said aqueous micelle solution so as to destroy said micelle and deposit the solubilized material on an electrode, thereby forming a thin film.

According to a further aspect of the present invention there is provided a non-linear switching element having a thin-film laminate structure comprising a conductive material, an organic insulating thin film and a conductive material, wherein said organic insulating thin film is formed by a method characterised by comprising the steps of solubilising an organic material, an inorganic material or a mixture thereof which is sparingly soluble or insoluble in water in an aqueous micelle solution of a surfactant which is charged by electrolysis, and carrying out electrolysis in said àqueous micelle solution so as to destroy said micelle and deposit the solubilized material on an electrode.

Said non-linear switching element may have a bi-directional non-linear characteristic.

Said organic insulating thin film is preferably composed of a phthalocyanine material.

The invention is illustrated, merely by way of example, in the accompanying drawings, in which:-

Figure 1 shows the structure of a colour filter according to the present invention;

Figure 2 shows the optical characteristic of the colour filter of Figure 1 as compared with conventional colour filters;

Figure 3 is an example of a substrate used for a colour filter according to the present invention;

Figure 4 shows the spectral characteristics of a colour filter according to the present invention as compared with conventional colour filters;

Figure 5 shows an example of a process for producing a colour filter according to the present invention;

Figure 6 shows an example of a process for producing a light-shielding film of a colour filter according to the present invention;

Figures 7 and 8 show examples of a process for producing an optical recording medium according to the present invention;

Figure 9 explains the structure of films of an electro-photographic photo-sensitive drum according to the present invention;

Figure 10 shows an example of non-linear characteristics of a non-linear switching element;

Figure 11 shows a process for producing a non-linear switching element according to the present invention; and

Figure 12 shows the bi-directional non-linear characteristics of a non-linear switching element according to the present invention.

The present invention is characterized by using a surfactant which is oxidisable and reducible by electrolysis. An aqueous micelle solution of a surfactant which is at least positively charged by electrolytic oxidation, and preferably also negatively charged by electrolytic reduction, is prepared. A supporting electrolyte is dissolved in the aqueous solution. Then fine particles of a substance from which a film is to be formed and which is sparingly soluble or insoluble in water, are dispersed in the aqueous solution in a colloidal state.

Generally, not all the particles of the film material dispersed in an aqueous micelle solution assume a colloidal state, but only secondary particles. Secondary particles are an aggregate of primary particles, having a particle size which allows the secondary particles to be separated from the aggregate and to continue Brownian movement. The particles dispersed in the aqueous micelle solution effectively assume a colloidal state when the solution is mechanically vehemently agitated by a propeller mixer or the like or when the particles are ultrasonically dispersed by an ultrasonic homogeniser or mechanically dispersed by a ball mill or the like. Immediately after dispersion, the particles which are to become colloidal particles and the particles which are too large for colloidal particles and are to precipitate in the long run are mixed with each other. The dispersion is permitted to stand for at least several hours and the supernatant is collected, or the particles too large to become colloidal particles are separated by centrifugal separation. In this way, an electrolytic solution is prepared.

In the thus-prepared electrolytic solution, appropriate electrodes (an anode and a cathode) are inserted. When electrolysis is carried out at a constant voltage not lower than the oxidation potential of the surfactant, electrolytic oxidation is caused on the anode, whereby the surfactant, which constitutes the micelle while surrounding the film material, is positively charged all at once and separates from the particles of the film material. As a result, the particles of the film material are released so as to deposit on the anode, thereby forming a film.

As the surfactant which is positively charged at least by oxidation due to electrolysis, those having a metallocene group with the following chemical composition at the hydrophobic end are contemplated:

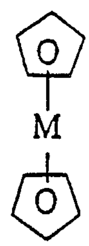

wherein M represents a metal such as Ti, Cu, V, Fe, Co, Ni, Ru and Os.

As a metallocene group, one mainly consisting of Fe is popular but it has been found that metallocene groups mainly consisting of Cr and Ti also exhibit a good film-forming property. Since the oxidation potential is different depending upon the metal, the metallocene group can be appropriately selected in accordance with the material used for the anode.

It is also essential for the surfactant that the main chain has a hydrophilic portion, that the whole molecule thereof is sufficiently hydrophilic to be soluble in water and that the surfactant constitutes a micelle.

Surfactants which satisfy the above-described conditions have now been found the adsorptivity of which surfactants can be enhanced by enlarging the hydrophobic group and the hydrophobic group of which surfactants can also be relatively enlarged so as to allow the material of a film to assume a stable micelle colloidal state in water.

It has also been found that surfactants having Cr or Ti in the metallocene group of the hydrophobic end group exhibit good properties in the formation of a metal phthalocyanine film. The chemical structure of the surfactants are:

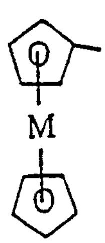

$C_{18}H_{36}O(CH_2CH_2O)_{20}H$

wherein M represents Cr or Ti.

The material of a thin film device according to the present invention is not specific and may be either an organic material or an inorganic material so long as the surface of the particles is surrounded by the

micelle of the surfactant. Even if the surface of the particles is not hydrophobic, it is usable if the surface nature is convertible into a hydrophobic nature.

As the film material of a thin film device according to the present invention, almost all organic pigments are usable.

As an inorganic material, oxides, nitrides, carbides as well as carbon are usable. In particular, inorganic oxides are easily formed into a thin film by making the surface hydrophobic.

A mixture of an organic material and an inorganic material is also usable.

In addition to both organic and inorganic materials composites of two or more such materials are possible. In the case of manufacturing a colour filter using an organic pigment, for example, use of a composite of pigments can produce a pigment film having the optimum spectral characteristic, as will be described later.

The diameter of the primary particles of the film material is preferably 0.005 to 0.5 m, more preferably 0.005 to 0.05 µm. To state this more concretely, in the method of manufacturing a thin film device according to the present invention, since the Brownian movement of the coloidal particles constitutes the main film-forming energy, the adhesion between the particles and the substrate (electrode) and the adhesion between the particles are weak. It is therefore necessary to secure the adhesion between the particles and the substrate and the adhesion between the particles, especially, during film formation by making the primary particle as fine as possible so as to enhance the surface energy and the cohesiveness. The above-described range of the particle diameter of the primary particles is therefore preferable.

If necessary a supporting electrolyte (an inorganic salt or an organic salt) is added to the electrolytic solution. Since a supporting electrolyte is added mainly for the purpose of control of the resistance of the solution, it is not particularly restricted unless it obstructs the formation of a micelle or film formation.

The supporting electrolyte is preferably added before the formation of a micelle. If it is added after the formation of a micelle, the micelle may be broken down due to the influence of the added ions, thereby introducing re-cohesion of the film material.

Doping, which has conventionally been tried on phthalocyanine material only in a dry process, is also enabled in a wet process and it is possible to provide conductivity thereby. This will be explained in detail as follows. As the film material, an organic material is used. In particular, an organic pigment is preferable. Above all, a phthalocyanine material has exhibited prominent conductivity. As a dopant, a halogen is effective. In particular, bromine and iodine are preferable. Doping is carried out by a wet process selected from the following two methods.

(1) Using a halogenated material as a supporting electrolyte in the electrolytic solution or adding a halogenated material such as LiBr, LiI, NaBr and NaI as a part of a supporting electrolyte so as to mix a halogen with the material of a film during the electrolysis.

(2) Immersing a thin film device in a solution containing a halogenated material as an anode after the film formation, thereby effecting electrolysis.

Four examples of the application of the present invention, namely, a colour filter for a display device, an optical recording medium, an electro-photographic photo-receptor and a non-linear switching element will be described herein.

A colour filter will first be described. A system of disposing a colour filter at the inside of a display panel for the purpose of colouring a liquid crystal display or a plasma display has conventionally been adopted.

A colour filter is conventionally manufactured by relief drying, printing, pigment dispersion, deposition, electro-deposition or the like. The present invention is different from those conventional processes in that a coloured layer solely consisting of an organic pigment is obtained by a wet process at a relatively low cost. Since the coloured layer solely consists of a pigment, the spectral characteristic have good colour purity even if the film thickness is 1 µm or less.

A colour filter composed of a transparent electrode of indium tin oxide (hereinafter referred to as "ITO"), tin oxide or the like formed on a transparent substrate so as to have a predetermined pattern and an organic pigment layer formed on the transparent electrode is manufactured in the following manner. A substrate (used as an anode) and an energising electrode (used as a cathode) are immersed in a solution of a solubilized water-insoluble organic pigment in an aqueous micelle solution of a surfactant. Conduction is established between a specified pattern of the transparent electrode and the cathode, thereby separating out the particles of the organic pigment on the transparent electrode. This process is repeated in the electrolytic solution containing different organic pigments and on other patterns of the transparent electrode.

Using a thin film device as a colour filter for a liquid crystal display is advantageous in that the transparent electrode used during electrolysis can also be used for driving the liquid crystal material itself.

In the application of a thin film device to a colour filter, it is sometimes difficult to obtain the desired spectral characteristic, which is the most important characteristic of a colour filter, by using only one kind of pigment for one coloured layer.

To solve this problem in the present invention, at least two kinds of pigments are dispersed in an electrolytic solution, so that the deposited film also contains at least two kinds of pigments and a coloured layer which is provided with the desired spectral characteristic is obtained.

In the case of forming a coloured pattern of three colours or more, if the electrode pattern on which a pigment film has already been formed is energized again due to the configuration of the pattern when electrolysis is carried out on another different electrode pattern, some pigment films exhibit conductivity, thereby involving a possibility of another pigment film being formed on the already formed pigment film.

To solve this problem, the present invention adopts a method of preventing conduction on the unselected electrode pattern when electrolysis is carried out by selectively establishing conduction on a specified electrode pattern by forming an insulating film or a high-resistance film on a part of the unselected electrode pattern in advance.

As a method of forming such an insulating film or a high-resistance film, a printing method and photo-lithography are effective, but electro-chemical polymerization is preferable in terms of cost. The material of an insulating film or a high-resistance film is not specific.

Methods of providing a light-shielding film between the transparent electrodes with the pigment films formed thereon will now be described. A light-shielding film is provided so as to prevent the transmitted backlight from leaking out of the gaps between the electrode patterns, thereby reducing the OFF/ON contrast.

A first method for providing a light-shielding film adopts photo-lithography in accordance with the following steps:

1. A transparent electrode having a predetermined pattern is formed on a transparent substrate.

2. A metal film is formed on the transparent electrode by electroplating or electroless plating. Electroplating makes it possible to form a metal film only on the transparent electrode. In the case of adopting electroless plating, a metal film is formed on the entire surface of the substrate. The unnecessary portion of the thus-formed metal film is removed by photo-lithography using a photo-sensitive resist on etching so as to form the metal film only on the transparent electrode. Alternatively, it is possible to form a metal film only on the transparent electrode by using a mixed catalyst of Sn and Pd, which is unlikely to be adsorbed by a transparent substrate of an inorganic material such as glass, quartz and rock crystal.

3. The surface of the substrate on which the transparent electrode and the metal film formed is coated with a photo-setting type photo-sensitive resin. The photo-sensitive resin may contain a light-shielding dye dissolved therein or a light-shielding pigment dispersed therein. A photo-sensitive resin which contains no dye or pigment is also usable.

4. When the other side of the substrate, which is not coated with the light-shielding film, is exposed to UV light, the metal film on the transparent electrode functions as an exposure mask, whereby only the resin between the transparent electrode patterns is set.

5. Subsequent development and baking steps form a light-shielding film between the transparent electrode patterns. In the case of using a photo-sensitive resin which contains no dye or pigment at step 3, the resin is dyed at the subsequent dyeing step.

6. After etching the metal film on the transparent electrode, a pigment film is formed thereby producing a colour filter according to the present invention provided with a light-shielding film (black matrix).

A second method for providing a light-shielding film adopts a printing method.

In the case of manufacturing a liquid crystal panel, for example, a light-shielding film is formed at the gaps between the transparent electrode patterns at which no pigment film for a colour filter has been formed by using an ink which contains a light-shielding material. Alternatively, a light-shielding film is formed on the opposing substrate at the portions facing the gaps between the transparent electrode patterns of the colour filter.

The light-shielding material contained in the ink is not specific but a black pigment having no electric conductivity is preferable.

The application of the present invention to an optical recording medium will now be described.

It is conventionally known that an organic compound including a pigment may be used as an optical recording medium. However, when conventional vacuum deposition is adopted for manufacturing such an optical recording medium, the characteristics of the resulting thin film are unstable depending upon the positional relationship between the source of evaporation and substrate in a vacuum chamber and the

heating conditions, and the production yield is low. In addition, vacuum deposition results in a high manufacturing cost.

On the other hand, in a method of coating a substrate with an organic compound which is dissolved in an organic solvent, since many compounds are sparingly soluble in water, the choice of organic compounds is inconveniently restricted.

To solve these problems, in the present invention, a colloidal solution of ultra-fine particles of an organic compound, which is sparingly soluble or insoluble in water, surrounded by a surfactant which is oxidisable and reducible by electrolysis so that the particles assume a colloidal state is formed. An optical disk substrate having electric conductivity is immersed in the colloidal solution and a voltage is applied between the optical disk substrate and an energising electrode so as to deposit the ultra-fine particles of the organic compound, which are surrounded by the surfactant, on the substrate, thereby forming a thin film.

As the optical disk substrate, a plastics substrate such as a polycarbonate substrate is generally used. Such a substrate is made electrically conductive by coating the substrate with an electrically conductive oxide such as ITO and $SnO_2$ or a metal by sputtering or vacuum deposition.

The application of the present invention to an electro-photographic photo-receptor will now be described.

An organic carrier generating layer of an electro-photographic photo-receptor is generally produced by vacuum deposition or there is adopted a coating method in which a carrier generating substance is dissolved in an appropriate solvent or an isochronous pulling method or the like, or a dispersion coating method in which a carrier generating substance is ground into fine particles, in a dispersion medium by a ball mill or the like and dispersing the fine particle together with an adhesive, if necessary.

However, vacuum deposition is not particularly appropriate to mass productivity. The conventional coating methods are also disadvantageous in that it is difficult to form a uniform film and since a carrier generating substance is dispersed in a resin such as a binder, the density of the organic photo-sensitive material in the film is lowered, which leads to the deterioration of characteristics.

In order to solve these problems, the present invention provides a high-efficiency carrier generating layer from various organic photo-sensitive materials with high productivity by forming a high-density and high-purity film.

According to the present invention, an organic photo-sensitive material (organic pigment) having a low solubility is solubilized in a solution by the micelle formed by a surfactant containing a metallocene group, and after an electrically conductive support and a counter electrode are immersed in the solution, a voltage is applied between the support and the counter electrode so as to deposit the organic photo-sensitive material in the micelle on the support, thereby forming a thin film.

The application of a thin film device of the present invention to a non-linear switching element will now be described.

It is conventionally known that a thin film laminate structure consisting of a metal, an insulating film and a metal (hereinafter referred to as "MIM") exhibits a bi-lateral non-linear characteristic such as that shown in Figure 10, and an MIM element consisting of Ta, $Ta_2O_5$ and Cr have been put to practical use as a liquid crystal switching element for a liquid crystal television.

The important factor in the efficiency of an MIM element as a liquid crystal driving switching element is a steep non-linear drop of resistance to voltage and it is therefore necessary that a voltage applied to the switching element is sufficient to retain the switching function. More specifically, if it is assumed that the MIM element and a liquid crystal layer have a linear structure, the smaller the capacitance of the element, namely, the capacitance of the insulating material of the element, the better.

In the case of using an inorganic oxide as the insulating material, the dielectric constant thereof is generally large, for example, 25 to 27 in the case of $Ta_2O_5$ Therefore, in order to reduce the capacitance, the area of the element should be reduced or the thickness of the insulating material should be increased (because

$$C = \frac{\varepsilon S}{9 \times 10^{11} \times 4\pi d}$$

wherein $\epsilon$ represents dielectric constant, S area, and d thickness).

However, even if the thickness is increased, the resistance is not made small enough, so that a method of reducing the area of the element is adopted in practice. The area of the switching element used in

practice in a liquid crystal television is 5 µm square, which requires a very highly accurate technique for production. In addition, much use of vacuum film-forming apparatus and dry etching devices reduces throughput, thereby disadvantageously raising manufacturing cost.

As described above, it is impossible to produce a bi-lateral non-linear liquid crystal driving switching element with easiness and at a low cost by conventional methods.

In order to solve these problems, according to the present invention, an organic material having a small dielectric constant is used as an insulating material, thereby allowing the switching element to have a large area, and the insulating material is formed from a phthalocyanine material, which is chemically stable, by a wet process, thereby realizing reduction in manufacturing cost.

It is known that a phthalocyanine material exhibits what is called diode characteristics, but no report has ever been made that a phthalocyanine material exhibits a bi-lateral non-linear characteristic such as that shown in Figure 10, and this fact can be said to have been discovered by the present inventors.

A non-linear switching element in accordance with the present invention is manufactured by forming an insulating film on a conductive material by a wet process, and further forming a film of a conductive material on the insulating film. The insulating film is formed by dispersing particles of an insulating material in an aqueous micelle solution of a surfactant which is charged by electrolysis so that the particles are surrounded by the micelle of the surfactant in a colloidal state, and immersing a conductive material, which is a substrate of a thin film device, in the solution as an electrode for effecting electrolysis, whereby the micelle is electrically destroyed and the particles of the insulating material surrounded by the micelle is deposited on the conductive material.

As the conductive material for the substrate, a metal, an oxide conductive material such as $In_2O_5$ and $SnO_2$ and the like are preferable.

As the insulating material, a phthalocyanine material is preferable and the particle diameter is preferably 0.005 to 0.5 µm as the diameter of the primary particles.

As the conductive material covering the insulating film, a metal and an oxide conductive material are preferable.

Example 1

Various thin film devices were manufactured from organic pigments such as copper phthalocyanine, halogenated copper phthalocyanine, an anthraquinone pigment, a thioindigo pigment, monochlorocopper phthalocyanine, a perylene pigment, a quinacridone pigment, a dioxazine pigment, a nitro pigment, a nitroso pigment, an azo complex salt pigment, a condensed azo pigment, a metal complex pigment, a benzoimidazolone pigment, aniline black, a daylight fluorescent pigment, an isoindolinone pigment, a quinophthalone pigment, a perinone pigment and a diketopyrrolopyrrole pigment as a film material and by using the following four surfactants.

**Surfactant A**

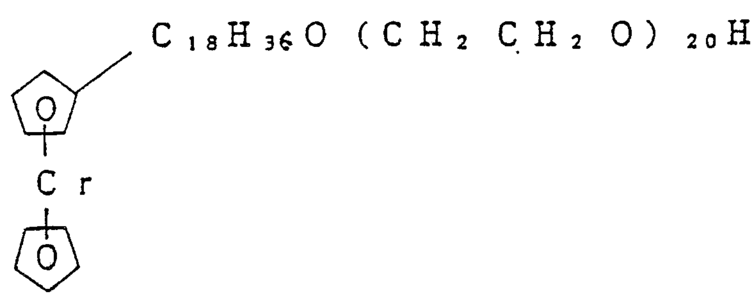

**Surfactant B**

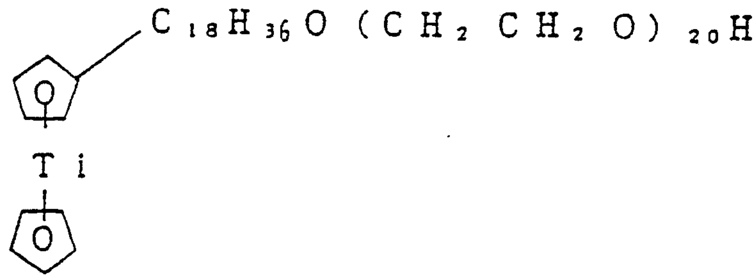

**Surfactant C**

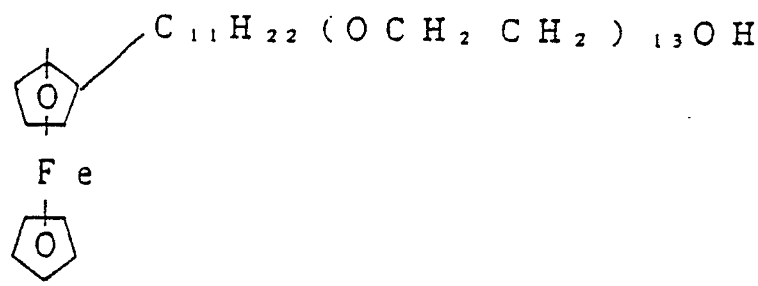

(Ferrocenyl-PEG, produced by Dojin Kagaku)

**Surfactant D**

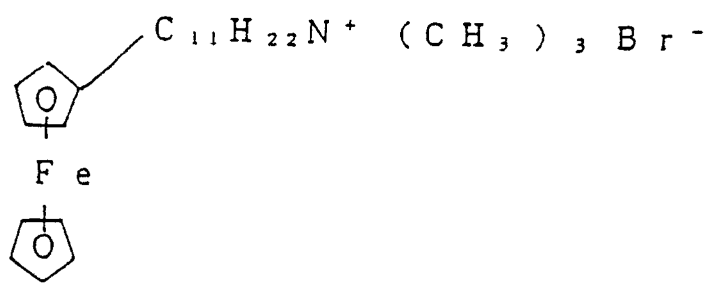

(Ferrocenyl-TMA, produced by Dojin Kagaku)

The surfactants A and B were developed by the present inventors with a view to obtaining optimum film-forming properties mainly of a phthalocyanine material. The surfactants C and D are commercially available. As a result, various pigment films were obtained (Table 1). The main experimental conditions are shown in Table 1.

The surfactant and the supporting electrolyte were dissolved in 600 ml of water and 2 to 10g/l of an organic pigment, as film material was added thereto. The pigment was dispersed for 1 hour using an ultrasonic homogeniser (RUS-600, produced by Nihon Seiki) and afterwards the dispersion was allowed to stand for 12 hours. 100 ml of the supernatant was collected.

The collected supernatant was charged in an H-type cell and electrolysis was carried out for 30 minutes in an $N_2$ atmosphere as an anode, a platinum plate as a cathode and a saturated calomel electrode (hereinafter referred to as "S.C.E.") as a reference electrode. After the electrolysis, the substrate on which the film had been formed was washed with water and dried.

Electrolysis was carried out in an $N_2$ atmosphere in order to prevent deterioration of the surfactant due to oxidation. The pigment having a large diameter of the primary particles had been pulverized chemically or physically in advance so as to have a particle diameter of not more than 0.5 $\mu$m.

| | Pigment | Surfactant | | Supporting electrolyte | | anode potential* | thickness of depo.film | Remark |
|---|---|---|---|---|---|---|---|---|
| | | Kind | concn. | Kind | concn. | | | |
| 1 | α type copper phthalocyanine | A | 3 | LiBr | 0.05 | +1.0V | 0.9 | Dainichi Seika K.K. |
| 2 | Phthalocyanine Green | A | ↑ | ↑ | ↑ | ↑ | 1.1 | BASF |
| 3 | Dianthraquinonyl red | A | ↑ | ↑ | ↑ | ↑ | 1.0 | Pigment Red 177 |
| 4 | Thioingido Magenda | A | ↑ | ↑ | ↑ | ↑ | 0.4 | Pigment Violet 177 |
| 5 | Monochlorocopper phthalocyanine | B | 2 | KCℓ | 0.1 | ↑ | 0.7 | Dainichi Seika K.K. |
| 6 | Perylene Red | B | ↑ | ↑ | ↑ | ↑ | 0.8 | Pigment Red 190 |
| 7 | Quinacridone Red | B | ↑ | ↑ | ↑ | ↑ | 0.6 | Pigment Violet 19 |
| 8 | Dioxazine Violet | C | 3 | $Li_2SO_4$ | 0.05 | +0.45 | 0.8 | Pigment Violet 23 |
| 9 | Naphthol Yellow-S | C | ↑ | ↑ | ↑ | ↑ | 0.4 | Acid Yellow 1 |
| 10 | Naphthol Green-B | C | ↑ | ↑ | ↑ | ↑ | 0.4 | Pigment Green 8 |
| 11 | Nickel Azoyellow | C | ↑ | ↑ | ↑ | ↑ | 0.5 | - |
| 12 | Chromophthal Yellow-GR | C | ↑ | ↑ | ↑ | ↑ | 0.5 | Pigment Yellow 95 |
| 13 | Irgazine Yellow-5GLT | C | ↑ | ↑ | ↑ | ↑ | 0.4 | Pigment Red 129 |
| 14 | Aniline Black | C | ↑ | ↑ | ↑ | ↑ | 0.4 | Pigment Red 176 |
| 15 | Lumogen Yellow | C | ↑ | ↑ | ↑ | ↑ | 0.4 | Pigment Black 1 |
| 16 | Benzoimidazolone HF3C | C | ↑ | ↑ | ↑ | ↑ | 0.4 | BASF |
| 17 | Isoendorinone Yellow Grrenish | D | 2 | ↑ | ↑ | +0.6 | 0.4 | Pigment Yellow 109 |
| 18 | Quinophthalone Yellow | D | ↑ | ↑ | ↑ | ↑ | 0.4 | Pigment Yellow 138 |
| 19 | Perinone Orange | D | ↑ | ↑ | ↑ | ↑ | 0.5 | Pigment Orange 43 |
| 20 | Irgazine DPP Red BO | D | ↑ | ↑ | ↑ | ↑ | 0.4 | Pigment Red 254 |

* V.S. S. C. E.

From these experiments, it is clear that the films of various pigments can be produced by a wet process.

Typical films are shown in Example 1 and the pigments and supporting salts in the present invention are not restricted to those shown in Table 1, but it will be seen that the surfactant A or B exhibited a good film-forming property with respect to a metal phthalocyanine pigment.

Example 2.

As the surfactant, Ferrocenyl-PEG (produced by Dojin Kagaku) having a metallocene group containing Fe was used. 1l of an aqueous micelle solution of 4 mM of Ferrocenyl-PEG was prepared. As a supporting electrolyte, 0.1 M/l of LiBr was added thereto.

15 g of a carbon powder having a particle diameter of 0.095 µm (the primary particles) was added to the solution as an inorganic material and dispersed by an ultrasonic homogeniser.

If the dispersion, a platinum plate, a saturated calomel electrode (S.C.E.) and a glass substrate provided with an ITO film were immersed as a counter electrode, a reference electrode and a sample electrode, respectively, so as to effect electrolysis for 1 hour at an electrolytic potential of + 5 V (VS. S.C.E.).

Thus, a carbon film was formed on the ITO film by a wet process.

Example 3.

An aqueous micelle solution of Ferrocenyl-PEG was prepared in the same way as in Example 2 and 15 g of a silica powder which had been treated so as to be hydrophobic was added thereto and dispersed by an ultrasonic homogeniser.

In order to make the silica powder hydrophobic, epoxy silane (SH-6040, produced by TORAY) was dissolved in silica sol (produced by Shokubai Kasei, particle diameter: 0.02.µm) in which had been dispersed isopropyl alcohol so as to have a concentration of 5 wt%, and after the solvent was evaporated, the residue was baked at 120° C for 1 hour, thereby introducing the epoxy group to the surface of the silica particles. After the baking, the silica particles were pulverized into a particle diameter of not more than 0.4 µm.

In the dispersion, a platinum plate, a saturated calomel electrode (S.C.E.) and a glass substrate provided with an ITO film were immersed as a counter electrode, a reference electrode and a sample electrode, respectively, so as to effect electrolysis for 1 hour at an electrolytic potential of + 0.5 V (VS. S.C.E.). Thus, an $SiO_2$ film was formed on the ITO film.

Example 4.

As a surfactant, the following having a metallocene group containing Cr was used:

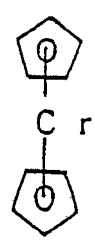

$C_{18}H_{35}O(CH_2CH_2O)_{20}H$

1l of an aqueous micelle solution of 3 mM of the surfactant was prepared. As a supporting electrolyte, 0.1M of LiBr was added thereto.

Monochlorocopper phthalocyanine, which is an organic material and a phthalocyanine pigment, was pulverized by a sand mill so that the maximum particle diameter of the primary particles was not more than 0.4 µm. The average particle diameter was not more than 0.05 µm. The particle diameter was measured by an SEM (S-900, produced by Hitachi, Ltd.).

5 g of the thus-prepared phthalocyanine was added to the micelle solution and dispersed by an ultrasonic homogeniser.

In the dispersion, a platinum plate, a saturated calomel electrode (S.C.E.) and a glass substrate provided with an ITO film were immersed as a counter electrode, a reference electrode and a sample electrode, respectively, so as to effect electrolysis for 30 minutes at an electrolytic potential of + 1.0 V (VS. S.C.E.). Thus, a film of monochlorocopper phthalocyanine of 4000 Angstrom thick was formed on the ITO film.

After the substrate was washed with running water and dried by blowing air, the substrate was baked at 200°C for 1 hour.

When an adhesive (Scotch - trade mark) tape was adhered to the substrate and pulled to be stripped off as an adhesion test, the monochlorocopper phthalocyanine film was not stripped at all.

For comparison, 5 g of monochlorocopper phthalocyanine before pulverisation with the sand mill was added to the micelle solution prepared in the same way as in the above experiment. The maximum diameter of the primary particles was 1 µm. The particle diameter was similarly measured by the SEM.

These particles were similarly dispersed in the micelle solution and film formation on a glass substrate provided with an ITO film was attempted, but when the substrate was drawn out of the solution, almost half the area of the film was stripped off. From the above experiments, it has been found that the particle diameter has a great influence on the adhesion and that the particle diameter must be not more than 0.5 um, preferably not more than 0.05.um.

Example 5.

1l of an aqueous micelle solution of 10 mM of Ferrocenyl-PEG was prepared. 20 g of a carbon powder having an average primary particle diameter of 0.05 µm and 0.1 M of LiBr were added thereto as an inorganic material and a supporting electrolyte, respectively, and dispersed by an ultrasonic homogeniser. By using the dispersion, a carbon film was formed on a glass substrate provided with an ITO film in the same way as in Example 1. The substrate was immersed in still water to be washed therewith, and dried with hot air. During this process, the carbon film was formed with good adhesion without being stripped off.

In the same way, a carbon powder having an average primary particle diameter of 3 µm was dispersed in the micelle solution. Although a carbon film was formed on a glass substrate provided with an ITO film in the same way, since the adhesiveness of the carbon film was poor, almost no film was formed. As is clear from this experiment, the particle diameter also has an influence on the adhesion in an inorganic material. The preferred particle diameter is not more than 0.5 um, more preferably not more than 0.05 um.

Example 6.

As the surfactant, the following substance was used.

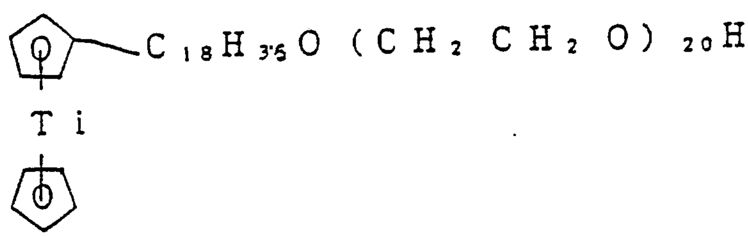

1l of an aqueous micelle solution of 3mM of the surfactant was prepared. As a supporting electrolyte, 0.1 M of LiBr was added thereto. Further, potassium iodide was added thereto as an iodine doping electrolyte. 14 g of Heliogen Green D914 produced by BASF was further added to the solution, and suspended in the solution by 15-minute ultrasonic treatment. The suspension was vehemently shaken for about 100 hours in a shaker and allowed to stand. Thereafter the supernatant was sampled and the particles which were not in a colloidal state were separated.

The supernatant was charged into an H-type cell, and a glass substrate provided with an ITO film, a platinum plate and a saturated calomel electrode (S.C.E.) were immersed as an anode, a cathode and a reference electrode, respectively, so as to effect electrolysis for 30 minutes in an $N_2$ atmosphere at an electrolytic potential of + 1.1 V (VS. S.C.E.). Thus, an iodine-doped phthalocyanine film was formed on the glass substrate provided with the ITO film. The film thickness was about 5000 Angstrom and the electric

conductivity was about 1.0 S/cm. The film formed without iodine doping had an electric conductivity of about 1 x $10^{-10}$ S/cm.

Example 7.

Pulse electrolysis was carried out by using the solution and the cell similar to those used in Example 6.

Repetitive pulses of 9 seconds at an electrolytic potential of + 0.9 V (VS. S.C.E.) and 1 second at an electrolytic potential of + 1.1 V (VS. S.C.E.) was applied for 30 minutes to obtain a phthalocyanine iodine film on the glass substrate provided with the ITO film. The film thickness was about 4500 Angstrom and the electric conductivity was about 1 x $10^{-1}$ S/cm.

Example 8.

1l of an aqueous micelle solution of 4 mM of a surfactant similar to that used in Example 6 was prepared. 0.2 M of LiI was added thereto as a supporting electrolyte and an iodine doping electrolyte. 10 g of alpha-type copper phthalocyanine was further added to the solution as a phthalocyanine pigment and treated for 1 hour by an ultrasonic homogeniser. After the suspension was allowed to stand, the supernatant was sampled.

The supernatant was charged into an H-type cell, and a glass substrate provided with an ITO film, a platinum plate and a saturated calomel electrode (S.C.E.) were immersed as an anode, a cathode and a reference electrode, respectively, so as to effect electrolysis for 40 minutes at an electrolytic potential of + 0.7 V (VS. S.C.E.). Thus, an iodine-doped phthalocyanine film was formed on the glass substrate provided with the ITO film. The film thickness was about 6000 Angstrom and the electric conductivity was about 2.0 S/cm. The film formed without iodine doping had an electric conductivity of about 1 x $10^{-11}$ S/cm.

Example 9.

1l of an aqueous micelle solution of 4 mM of a surfactant similar to that used in Example 6 was prepared. 0.2 M of LiBr was added thereto as a supporting electrolyte and a bromine doping electrolyte. 10 g of alpha-type copper phthalocyanine was further added to the solution as a phthalocyanine pigment and dispersed for 1 hour by an ultrasonic homogeniser. After the suspension was allowed to stand, the supernatant was sampled.

The supernatant was charged into an H-type cell, and a glass substrate provided with an ITO film, a platinum plate and a saturated calomel electrode (S.C.E.) were immersed as an anode, a cathode and a reference electrode, respectively, so as to effect electrolysis for 30 minutes in an $N_2$ atmosphere at an electrolytic potential of + 1.0 V (VS. S.C.E.). Thus, a bromine-doped phthalocyanine film was formed on the glass substrate provided with the ITO film. The film thickness was about 5000 Angstom and the electric conductivity was about 1 x $10^{-2}$ S/cm. Thus, the doping effect was observed.

Example 10.

As the surfactant, the following substance was used:

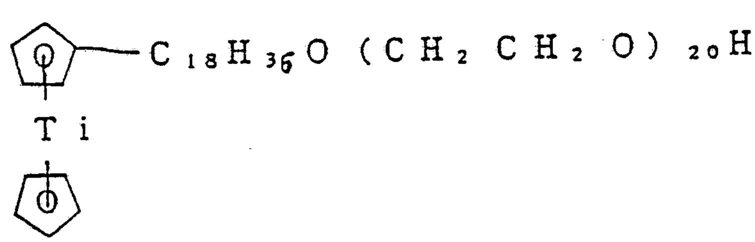

1l of an aqueous micelle solution of 3 mM of the surfactant was prepared. As a supporting electrolyte, 0.1 M of $Li_2SO_4$ was added thereto. 10 g of alpha-type copper phthalocyanine was further added to the

solution as a phthalocyanine pigment and dispersed in the solution for 90 minutes by an ultrasonic homogeniser. After the dispersion was allowed to stand, the supernatant was collected and the particles which were not in a colloidal state were separated.

The supernatant was charged into an H-type cell, and a glass substrate provided with an ITO film, a platinum plate and a saturated calomel electrode (S.C.E.) were immersed as an anode, a cathode and a reference electrode, respectively, so as to effect electrolysis for 30 minutes in an $N_2$ atmosphere at an electrolytic potential of + 0.8 V (VS. S.C.E.). Thus, a phthalocyanine film of 5000 Angstrom thick was formed on the glass substrate provided with the ITO film.

The glass substrate provided the ITO film and the phthalocyanine film formed thereon was immersed in a solution of 1.0 M of potassium iodide. Electrolysis was carried out for 10 minutes at an electrolytic potential of + 1.1 V (VS. S.C.E.) while using the glass substrate thereon as an anode and a platinum plate as a cathode. After the thus obtained iodine-doped phthalocyanine film was dried at 150 °C, the electric conductivity was measured 1.5 S/cm. The film formed without iodine doping had an electric conductivity of about 1 x $10^{-10}$ S/cm.

Example 11.

A phthalocyanine film was formed on a glass substrate provided with an ITO film in the same way as in Example 10 and iodine was doped by using 1.0 M of LiI solution in the same way as in Example 10.

The electrolytic potential was + 0.7 V (VS.S.C.E.) and the time for electrolysis was 10 minutes. After the thus-obtained iodine-doped phthalocyanine was heated and dried at 150 °C, the electric conductivity was measured 1.4 S/cm.

In Examples 6 to 11, it was possible to make the phthalocyanine pigment conductive by a wet process simultaneously or continuously with the film formation.

Iodine and bromine deposit only on the electrode, and no deposition is found on the other portions. Since doping is carried out in solution, this method for making the pigment conductive dispenses with a countermeasure for the leakage of discharged gas or the like.

Since it is possible to apply a uniform voltage to the electrode, the thickness of the film formed is uniform.

Not only from the point of view of characteristics but from the point of view of cost, this doping method is more advantageous than conventional doping method using vapor. According to the present invention, the application of a phthalocyanine pigment to thin film devices can be expected to increase.

Example 12.

Application of a thin film device to a colour filter for a liquid crystal panel will now be described. An ITO film of 1000 Angstrom thick was formed on a soda glass substrate having a diagonal of 150mm (6 inch) long by sputtering while heating the substrate to 300 °C. The thus-formed ITO film was patterned into a predetermined pattern by photo-lithography. A predetermined pattern of the ITO film was connected to a power source and immersed together with a platinum plate as a counter electrode in an electrolytic solution with an organic pigment dispersed therein.

The electrolytic solution was prepared in the following way. As the surfactant, Ferrocenyl-PEG (produced by Dojin Kagaku) having a metallocene group was used. 1l of an aqueous micelle solution of 3 mM of Ferrocenyl-PEG was prepared. As a supporting electrolyte, 0.2 M of LiBr was added thereto and 1.2 g of a red anthraquinone pigment, Chromophthal A3B (produced by Ciba Geigy) was added as an organic pigment. Those substances were suspended in the aqueous micelle solution of the surfactant by stirring them.

The suspension was ultrasonically treated for 1 hour by an ultrasonic homogeniser and after it was allowed to stand for 12 hours, 0.8 l of the supernatant was collected as the electrolytic solution.

A voltage was applied to the predetermined pattern of the ITO film while using the glass substrate with the patterned ITO film, a platinum plate, and a saturated calomel electrode (S.C.E.) as an anode, a cathode and a reference electrode, respectively, so as to effect electrolysis for 30 minutes at an electrolytic potential of + 0.4 V (VS. S.C.E.).

After electrolysis, the glass substrate provided with the ITO film was washed with water and dried. Thus, a red pigment film of Chromophthal A3B was formed on the ITO film to a thickness of 0.8 µm.

Similarly, an electrolytic solution was obtained by preparing 1l of an aqueous micelle solution of 3 mM

of Ferrocenyl-PEG (produced by Dojin Kagaku) as a surfactant and adding thereto 0.2 M of LiBr as a supporting electrolyte and 1.2 g of a blue anthraquinone pigment. Indanthrene Blue (Pigment Blue 60, CI 69800) as an organic pigment.

A voltage of + 0.4 V (VS. S.C.E.) was applied to another predetermined pattern of the ITO film while using the glass substrate with the patterned ITO film and a platinum plate as an anode and a cathode, respectively, so as to effect electrolysis. As a result, a blue pigment film of 0.7 µm thick was formed.

In the same way, an electrolytic solution was prepared by using a metal phthalocyanine pigment, Heliogen Green D9140 (produced by BASF) as a green organic pigment.

In the electrolytic solution, the ITO substrate with the red and blue pigment films formed thereon was immersed together with a platinum plate. A potential of + 0.5 V (VS. S.C.E.) was applied to the ITO pattern with no pigment film formed thereon for 30 minutes so as to effect electrolysis. Thus, a green phthalocyanine film of 0.8 µm thick was formed.

In this way, a three-coloured colour filter, having red, blue and green pigment films 1 formed on predetermined ITO patterns 2 themselves formed on a substrate 3 was obtained, as shown in Figure 1. Since this colour filter was only composed of the pigments, it exhibited sufficient colour densities in the respective film thicknesses.

By using this colour filter, a liquid crystal panel of the TN (twisted nematic) liquid crystal type was produced so as to have a cell gap thickness of 10 µm.

By applying a sine wave of 64 Hz to red picture elements, the relationship between the practically applied voltage of the liquid crystal panel and the intensity of the light transmitted through the liquid crystal panel was examined.

For comparison, a liquid crystal panel having a colour filter produced by a relief dyeing method and a liquid crystal panel having no colour filter were produced and the same characteristic was examined. The dyed colour filter was obtained by forming a photo-sensitive gelatin layer of 1.5 um thick on a glass substrate provided with an ITO pattern by spin coating, and dyeing the photo-sensitive gelatin layer red with an acidic dye. The film thickness was preset at 1.5 µm in order to obtain the colour density of the same degree as that of the red pigment filter according to the present invention.

The results of the tests are shown in Figure 2. The abscissa represents the practically applied voltage, and the ordinate the transmittance. The relationship between the voltage and the transmittance is shown on the assumption that the transmittance at an applied voltage of 0 is 0, and the maximum light transmittance of each panel is 100 in order to facilitate comparison.

The threshold potential of the liquid crystal panel of the present invention represented by the curve 1 is increased by about 5% in comparison with that of the liquid crystal panel having no colour filter layer which is represented by the curve 2. However, in comparison with the liquid crystal panel having a colour filter produced by a relief dyeing method which is represented by the curve 3, the liquid crystal panel 2 of the present invention exhibits a large reduction in the threshold voltage and a steep change in transmittance, which are desirable characteristics for a colour liquid crystal panel.

These desirable characteristics are ascribed to the fact that the colour filter of the present invention was composed only of a pigment.

From the point of view of manufacture, a colour filter according to the present invention, which adopts photo-lithography only in patterning an ITO film and uses no vacuum apparatus, is excellent from the viewpoint of mass productivity.

The electrode used for electrolysis is also used for driving a liquid crystal in the present invention. However, the rise in the driving voltage when a colour filter layer is formed on the electrode is very small and the margin for the withstand voltage of a conventional IC is enlarged. In addition, since it is possible to form an ITO film for driving a liquid crystal (the ITO film used for electrolysis) on a glass substrate, the ITO film has a high crystalinity, a low resistivity and a high durability, so that the colour filter can provide a liquid crystal panel having a high reliability.

Example 13

In order to form a blue-violet coloured layer, 100 ml of a colloidal solution of two kinds of pigments having the following composition was prepared.

| 1. Pigment | |
|---|---|
| a. beta-type copper phthalocyanine (blue-green pigment) | 7 mM |
| b. Dianthraquinonyl Red (red-violet pigment) | 3 mM |
| 2. Surfactant which is oxidisable and reducible by electrolysis Ferrocenyl-PEG (produced by Dojin Kagaku) | 2.5 mM |
| 3. Supporting electrolyte LiBr | 0.05 M |

An ITO (indium tin oxide) film, which was a transparent electrode, was formed into a stripe pattern having a thickness of 1500 Angstrom on a borosilicate glass substrate having a diagonal of 125 mm (5 inch) long, as shown in Figure 3, and electric conduction was selectively established on the pattern 11. The borosilicate glass substrate, a platinum electrode and a saturated calomel electrode (S.C.E.) were immersed in the above aqueous solution as an anode, a cathode and a reference electrode, respectively.

Electrolysis was carried out in a nitrogen atmosphere at an electrolytic potential of + 0.4 V (VS. S.C.E.) for 30 minutes. After the electrolysis, the substrate was washed with water and baked at 180° C so as to enhance the adhesiveness of the deposited film.

In this way, a vivid blue-violet thin film of 7000 Angstrom thick was formed on an ITO stripe pattern 11 in Figure 3. The spectral characteristic of the pigment thin film was sufficient as a colour filter, as indicated by a curve 11 in Figure 4.

In order to form a green coloured film on the substrate provided with the blue violet film, electric conduction was then selectively established on an ITO stripe pattern 12 in Figure 3, and electrolysis was carried out in a micelle colloidal solution of two types of pigment having the following composition under the same conditions as in forming the blue violet film.

| 1. Pigment | |
|---|---|
| a. beta-type phthalocyanine (blue-green pigment) | 6 mM |
| b. Quinophthalone pigment (yellow pigment) Paliotol Yellow LO962HD, produced by BASF | 4 mM |

The other composition was the same as in forming the blue-violet film.

In this way, a vivid green pigment thin film of 8500 Angstrom thick was formed by selectively establishing electric conduction on the ITO stripe pattern 12. The spectral characteristic of the pigment film was sufficient as a colour filter, as indicated by a curve 12 in Figure 4.

In order to further form a red coloured layer on the substrate provided with the blue violet thin film and the green thin film, electric conduction was then selectively established on an ITO shape pattern 13 in Figure 3, and electrolysis was carried out in a micelle colloidal solution of three types of pigment having the following composition under the same conditions as in forming the blue-violet film.

| 1. Pigment | |
|---|---|
| a. Dianthraquinonyl Red (red-violet pigment) | |
| b. Quinophthalone pigment (yellow pigment) Paliotol Yellow LO962HD, produced by BASF | 2 mM |
| c. Thioindigo magenta (red-violet pigment) | 1 mM |

The other composition was the same as in forming the blue-violet film.

In this way, a vivid red pigment thin film of 9000 Angstrom thick was formed on the selectively conductive ITO stripe pattern 13. The spectral characteristic of the pigment thin film was sufficient as a colour filter, as indicated by a curve 13 in Figure 4.

The curves 14, 15 and 16 show examples of the spectral characteristics of colour filters in the prior art each of which is composed of only one kind of pigment, namely alpha-type copper phthalocyanine, halogen-substituted copper phthalocyanine, and dianthraquinonyl red, respectively. It is clear that all of these conventional colour filters have insufficient spectral characteristics.

As described above, according to the present invention, a colour filter consisting of three primary colours of red, green and blue violet provided with good spectral characteristics such as those represented

by the curves 11, 12 and 13 in Figure 4 was obtained.

A colour filter of the present invention is not restricted to a three-coloured colour filter, and the order of colouring is not restricted to that in Example 13, either.

As described above, the manufacture of a colour filter having a desired spectral characteristic is facilitated by using an electrolytic solution of a mixture of a plurality of pigments. The method of the present invention facilitates the production of a rich variety of colour tones and is therefore effective for the application to decoration or the like.

Example 14.

A transparent substrate having a diagonal of 12 mm (5 inch) long with the ITO (indium tin oxide) transparent electrode formed into a stripe pattern thereon, as shown in Figure 5, was used.

In order to form a blue violet coloured layer, 1,000 ml of a colloidal solution of a pigment having the following composition was prepared.

| | |
|---|---|
| 1. Pigment Monochlorocopper phthalocyanine | 7 mM |
| 2. Surfactant which is charged by electrolysis Ferrocenyl-PEG (produced by Dojin Kagaku) | 3 mM |
| 3. Supporting electrolyte LiBr | 0.05 M |

After electric conduction was selectively established with a carbon paste on a electrode pattern 21 at the position represented by a broken line 24 in Figure 5, the transparent substrate was immersed in the colloidal solution. The region of the transparent substrate immersed in the colloidal solution is represented by an arrow 25 in Figure 5. Electrolysis was carried out at a constant voltage of 0.9 V for 30 minutes while using the transparent electrode as an anode and a stainless plate as a cathode.

In this way, a blue-violet pigment film of monochlorocopper phthalocyanine was formed on the stripe electrode pattern 21 in Figure 5 (in the region immersed in the solution) to a thickness of 8000 Angstrom thick. The substrate was washed with water and baked at 180°C so as to enhance the adhesiveness of the pigment film.

An aqueous solution having the following composition was next prepared and after electric conduction was selectively established at the position represented by the broken line 24 in Figure 5 in the same way, the substrate provided with the blue-violet film was immersed by an arrow 26. Electrolysis was carried out at a constant potential of + 0.7 V with respect to a saturated calomel electrode for 10 minutes.

| Composition of electrolytic solution | | |
|---|---|---|
| Aniline | | 0.1 M |
| Mg $(ClO_4)_2$ | 0.05 M | 0.05 M |

As a result, an electro-chemically polymerised aniline film having a high electric resistance was formed to a thickness of 7000 Angstrom only in a region 27 of the electrode pattern 21. No aniline polymerised film was formed on the blue-violet monochlorocopper phthalocyanine film, which was conductive. This is because the surface potential of the monochlorocopper phthalocyanine film does not reach the potential at which aniline is polymerised due to the potential drop.

The substrate was washed with water and dried at 120°C for 15 minutes.

After electric conduction was selectively established with a carbon paste on the substrate at the position represented by a broken line 28 in Figure 5, the transparent substrate was immersed in the colloidal solution of a pigment having the following composition. Electrolysis was carried out under the same condition in the above-described colloidal solution of the pigment.

| | |
|---|---|
| 1. Pigment Dianthraquinonyl Red | 8 mM |
| 2. Surfactant which is charged by electrolysis Ferrocenyl-PEG (produced by Dojin Kagaku) | 3 mM |
| 3. Supporting electrolyte LiBr | 0.05 M |

A red film of dianthraquinonyl red was formed only on an electrode pattern 22 but was not formed on the blue-violet pigment film formed on the electrode pattern 21.

That is, the red pigment film was selectively formed on the electrode pattern 22 because the aniline polymerised film existed at the portion of the electrode pattern 21 to which the carbon paste was applied, and the aniline polymerised film insulated the electrode pattern 21.

The transparent substrate was heated and baked at 180°C for 30 minutes so as to enhance the adhesiveness of the red pigment film.

Electric conduction was next selectively established only on the electrode pattern 23 at the position represented by a broken line 29 in Figure 5, and electrolysis was carried out in the colloidal solution of a pigment having the following composition. The conditions for electrolysis were the same as in the formation of the above-described colour pigment films.

| | |
|---|---|
| 1. Pigment Copper phthalocyanine bromochloride | 8 mM |
| 2. Surfactant which is charged by electrolysis Ferrocenyl-PEG (produced by Dojin Kagaku) | 3 mM |
| 3. Supporting electrolyte LiBr | 0.05 M |

In this way, a green pigment film of 8000 Angstrom thick was formed on the electrode pattern 23.

Thus, a colour filter consisting of three primary colours of blue, red and green was obtained.

The pigments, surfactant, supporting electrolyte used and the film-forming conditions are not restricted to those in Example 14. The material of an insulating film or a high-resistance film formed by electrochemical polymerisation and the film forming conditions are not restricted to those in Example 14, either. As the material of the insulating film dimethyl aniline, diethyl aniline, pyrrole, dimethyl phenol and diethyl phenol are also effective.

As described above, according to the present invention, when a new colour pigment film is formed on a conductive pigment film of another colour, the pigment film of the desired colour is easily selectively formed on the desired electrode pattern without overlapping with the previously formed pigment film. The method of the present invention can be said to be effective in terms of simplicity, low cost and mass productivity.

Example 15.

1. An ITO film 32 having a predetermined pattern was formed on a glass substrate as a transparent substrate 31 (Figure 6(a)).

2. The substrate was immersed in a mixed catalyst of Sn and Pd prepared in advance (HS-101B), produced by Hitachi Chemical Co. Ltd.) for 1 minute and thoroughly washed with water. Thereafter, the substrate was immersed in an aqueous NaOH solution of 1N for 1 minute for acceleration and thoroughly washed with water.

2. The substrate was immersed in a nickel electroless plating solution prepared in advance (S680, produced by Nihon Kanizen) at 50°C for 5 minutes, thereby obtaining an electrolessly plated nickel film 33 of 4000 Angstrom only on the ITO film (Figure 6(b)).

3. The nickel-plated surface of the substrate was coated with a black overcoat layer 34 having oxygen barrier properties to a thickness of 2 µm by spin coating black of a colour mosaic system produced by Fuji Hanto Electronics Technology K.K. The opposite side of the substrate to the black layer was exposed to UV light and thereafter the substrate was developed in a predetermined solution. The self alignment exposure removed the black layer on the electrolessly plated nickel film, thereby leaving the black layer only between the nickel films. Thereafter, the substrate was immersed in a concentrated nitric acid solution to dissolve and remove the electrolessly plated nickel film on the ITO film (Figures 6(c) and 6-(d)).

4. Pigment films 35 of red, green and blue (hereinafter referred to as "R", "G" and "B", respectively) were formed on predetermined ITO electrode patterns by an electrolytic method in accordance with the present invention (Figure 6(e)).

The electrolytic solutions for the film formation of R, G and B had the following compositions, respectively:

| | | |
|---|---|---|
| R: | Ferrocenyl-PEG (produced by Dojin Kagaku) | 2 mmol/l |
| | LiBr | 0.1 mol/l |
| | lChlormopththal A3B (Produced by Chiba Geigy) | 6 g/l |
| G: | Ferrocenyl-PEG | 2 mmol/l |
| | LiBr | 0.1 mol/l |
| | Phthalocyanine Green (produced by BASF) | 10 g/l |
| B: | Ferrocenyl-PEG | 2 mmol/l |
| | LiBr | 0./1 mol/l |
| | Monochlorocopper phthalocyanine (produced by Dainichi Seika) | 10 g/l |

These electrolytic solutions were thoroughly dispersed by an ultrasonic homogeniser.

A platinum plate was used as a counter electrode and a saturated calomel electrode was used as a reference electrode. The films were formed in the order of G, B and R, but the order is arbitrary.

In this way, a pigment film colour filter provided with a black matrix was obtained.

Example 16.

An electrolessly plated nickel film of 4000 Angstrom thick was formed on the ITO electrode having a predetermined pattern in the same process as in Example 15.

Thereafter, a photo-setting gelatin layer was formed on the nickel film side of the substrate to a thickness of 2 µm by spin coating, and after the opposite side of the substrate to the gelatin layer was exposed to UV light, the substrate was developed in a predetermined solution. The self alignment exposure removed the gelatin layer on the electrolessly plated nickel film, thereby leaving the gelatin layer only between the nickel films. Thereafter, the substrate was immersed in a concentrated nitric acid solution to dissolve and remove the electrolessly plated nickel film on the ITO film.

The gelatin layer remaining between ITO electrode patterns was dyed with a black dye. As the black dye, 10 g/l of B181 produced by Nippon Kayaku Co., Ltd. was heated to 60°C and the substrate was immersed therein.

Pigment films of R, G and B were formed on predetermined patterns of the ito film by the same process as in Example 15, thereby manufacturing a colour filter with a black matrix.

Example 17.

An electrolessly plated nickel film of 4000 Angstrom thick was formed on the ITO electrode having a predetermined pattern in the same process as in Example 15.

Thereafter, a photo-setting resin layer containing a light-shielding material was formed on the nickel film side of the substrate to a thickness of 2 µm by spin coating.

The photo-setting resin had the following composition:

| | |
|---|---|
| Denacole | 100 g |
| Benzophenone | 2 g |
| Titanium Black (produced by Mitsubishi Metal Corp.) | 20 g |

and used after being kneaded between two rolls.

After, the opposite side of the substrate to the photo-setting resin layer was exposed to UV light, the substrate was developed in a predetermined solution. The self alignment exposure removed the gelatin layer on the electrolessly plated nickel film, thereby leaving the resin layer only between the nickel films. Thereafter, the substrate was immersed in a concentrated nitric acid solution to dissolve and remove the electrolessly plated nickel film on the ITO film.

Pigment films of R, G and B were formed on predetermined patterns of the ITO film by the same process as in Example 15, thereby manufacturing a colour filter with a black matrix.

Example 18.

An ITO transparent electrode having a predetermined pattern was formed on a transparent substrate.

Pigment films of R, G and B were formed on predetermined ITO electrode patterns.

The electrolytic solutions for the film formation of R, G and B had the following compositions, respectively, and the following surfactant was used:

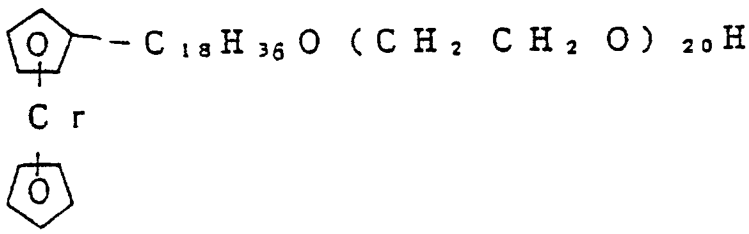

| | | |
|---|---|---|
| R: | Surfactant | 2 mM |
| | LiBr | 0.1 M |
| | Dianthraquinonyl Red (produced by Chiba Geigy) | 6 g/l |
| G: | Surfactant | 2 mM |
| | LiBr | 0.1 M |
| | Phthalocyanine Green (produced by BASF) | 10 g/l |
| B: | Surfactant | 2 mM |
| | LiBr | 0.1 M |
| | Monochlorocopper phthalocyanine (produced by Dainichi Seika) | 10 g/l |

These electrolytic solutions were thoroughly dispersed for 1 hour by an ultrasonic homogeniser, and the supernatant was collected after the dispersion had been allowed to stand for 10 hours.

Electrolysis was carried out at a potential of + 1.0 V (VS. S.C.E.) for 30 minutes while using a platinum plate as a counter electrode and the S.C.E. as a reference electrode, whereby pigment films were obtained, each having a thickness of about 1 µm. The films were formed in the order of G, B and R, but the order is arbitrary.

A black ink layer was printed between the transparent electrode patterns on the substrate with the R, G and B pigment films formed thereon by offset printing so as to form a light-shielding film. The plate used for the printing was a TORAY waterless lithography (negative plate) and a pattern which allowed an ink layer to be formed only between the transparent electrode patterns was formed. As a black ink, an ink composed of a red pigment and a black pigment with a slight amount of carbon dispersed therein was used.

Example 19.

On a counter electrode substrate to a colour filter used for a liquid crystal panel, a black ink layer of the same pattern as in Example 18 was formed by offset printing. The counter electrode substrate was pasted to the colour filter provided with R, G and B pigment films as a liquid crystal panel through a constant cell gap, whereby the black ink layer on the opposing substrate served as a light-shielding film.

As is clear from Examples 15 to 19, it was possible to prevent the lowering of the contrast due to the leakage of light from the gap between the R,G and B pigment films.

Example 20.

Figures 7(a) to 7(d) are sectional views of the process for manufacturing an optical recording medium in accordance with the present invention and the structure of the films. An optical disk substrate 41 is a polycarbonate substrate of 1.2 mm thick produced by injection molding.

To provide conductivity, an ITO (indium tin oxide) film 42 was formed on the surface of the grooves to a thickness of 600 Angstrom by sputtering (the inner and outer periphery of the grooves was masked to prevent the formation of the ITO film).

The substrate was next immersed in a micelle electrolytic solution in which the fine particles of an

indolenine cyanine pigment were surrounded by a surfactant so as to be in a colloidal state. Electrolysis was carried out while applying a voltage between the substrate and a stainless steel plate as a cathode so as to form an organic pigment film 43 about 800 Angstrom thick on the surface of the optical disk substrate.

A double-sided optical disk (d) is completed by pasting two of the thus-produced optical disks with each other through a spacer 44.

As the surfactant in the electrolytic solution, Ferrocenyl-PEG (produced by Dojin Kagaku) was used. THE composition of the electrolytic solution and the conditions for the electrolysis were as follows:

| Composition | |
|---|---|
| Ferrocenyl-PEG<br>LiBr (supporting electrolyte)<br>Indolenine cyanine pigment | 2 mM<br>0.2 M<br>7 mM |
| Conditions for electrolysis | |
| Potential<br>Time<br>Temperature<br>Stirring | 0.9 V<br>5 min.<br>25 °C<br>Gentle Stirring |

Example 21.

The process for manufacturing another optical recording medium in accordance with the present invention and the structure of the films will also be explained with reference to Figures 7(a) to 7(d). The optical disk substrate 41 is a polycarbonate substrate of 1.2 mm thick produced by injection molding.

To provide conductivity, the ITO (indium tin oxide) film 42 was formed on the surface of the grooves to a thickness of 800 Angstrom by sputtering (the inner and outer periphery of the grooves as masked to prevent the formation of the ITO film).

The substrate was next immersed in an electrolytic solution in which the fine particles of an indolinobenzopyran compound were surrounded by a surfactant so as to be in a colloidal state. Electrolysis was carried out while applying a voltage between the substrate and a stainless steel plate as a cathode so as to form an organic photo-chromic film 43 about 1000 Angstrom thick on the surface of the optical disk substrate.

The double-sided optical disk (d) is completed by pasting two of the thus-produced optical disks with each other through the spacer 44.

As the surfactant in the electrolytic solution, Ferrocenyl-PEG (produced by Dojin Kagaku) was used. The composition of the electrolytic solution and the conditions for the electrolysis were as follows:

| Composition | |
|---|---|
| Ferrocenyl-PEG<br>LiBr (supporting electrolyte)<br>Indolinobenzopyran pigment Spiropyran | 3 mM<br>0.4 M<br>9 mM |
| Conditions for electrolysis | |
| Potential<br>Time<br>Temperature<br>Stirring | 1.0 V<br>7 min.<br>30 °C<br>Gentle stirring |

As shown in Examples 20 and 21, the present invention facilitates the formation of an organic pigment thin film on an optical disk substrate by a wet process, which is sufficed with a simple apparatus and has a high productivity. Thus, mass production of high-efficiency optical disks at a low cost is enabled.

Example 22.

Figures 8(a) to 8(d) are sectional views of the process for manufacturing still another optical recording medium according to the present invention and the structure of the films.

An optical disk substrate 51 is a glass substrate of 1.2 mm thick with grooves produced on the surface thereof by plasma etching.

To provide conductivity, an ITO (indium tin oxide) film 52 was formed on the surface of the grooves to a thickness of 700 Angstrom by sputtering.

The substrate was next immersed in an electrolytic solution in which the fine particles of tetrasodium tetraporphyrin (hereinafter referred to as "TSTP") and polymethyl methacrylate (hereinafter referred to as "PMMA") were surrounded by a surfactant which are oxidisable and reducible by electrolysis so as to be in a micelle colloidal state. Electrolysis was carried out while applying a voltage between the substrate and a stainless steel plate as a cathode so as to deposit both TSTP and PMMA on the surface of the optical disk substrate 1, thereby forming a thin film 53 of a compound about 1000 Angstrom thick and having a photo-chemical hole burning (hereinafter referred to as "PHB") effect.

An optical disk (d) is completed by providing a protective coat 54 on the surface of the disk 1.

As the surfactant in the electrolytic solution, Ferrocenyl-PEG (produced by Dojin Kagaku) was used. The composition of the electrolytic solution and the conditions for the electrolysis were as follows:

| Composition | |
|---|---|
| Ferrocenyl-PEG | 3 mM |
| LiBr (supporting electrolyte) | 0.4 M |
| TSTP | 8 mM |
| PMMA | 10 mM |
| Conditions for electrolysis | |
| Potential | 1.0 v |
| Time | 10 min. |
| Temperature | 28 °C |
| Stirring | Vehement stirring |

As described above, the present invention facilitates the formation of a thin film of a compound having a PHB effect on an optical disk substrate by a wet process.

A thin film of a compound having a PHB effect which is formed in accordance with the present invention is uniformly formed on a disk substrate. Since the dispersion of the material having a PHB effect as a guest into a host (transparent solid medium) is homogeneous, the characteristics are very stable. Since this method is sufficed with a simple apparatus and has a high productivity, mass production of high-efficiency optical disks at a low cost is enabled.

Example 23.

Figure 9 explains the structure of the films of an electro-photographic photo-sensitive drum in accordance with the present invention.

In this embodiment, as a conductive support 61, an aluminium cylinder 30 mm in diameter, 1.5 mm in thickness and 20 cm in length was used. The surface was plated with a Cu layer 64 to a thickness of 2 um and after mirror polishing, a chi-type phthalocyanine photo-sensitive layer 62 (carrier generating layer, hereinafter referred to as "CGL")) was formed to a thickness of about 0.5 um. Further, a carrier transporting layer 63 (hereinafter referred to as "CTL") of polyvinyl carbazole (hereinafter referred to as "PVK") was formed to a thickness of about 20 µm.

A method of producing this embodiment will be explained in the following.

The aluminium drum was finished by diamond turning so as to have a surface roughness of 0.002 µm.

After the surface was plated with Cu to a thickness of 2 µm, the surface was finished by a polishing tape No. 6000.

The drum was thereafter immersed in a solution in which chi-type phthalocyanine was solubilized and electrolysis was carried out between the drum and a counter electrode so as to form a chi-type phthalocyanine thin film on the surface of the drum as a CGL.

In order to solubilise chi-type phthalocyanine which is difficult to dissolve in a solvent, the method of the present invention uses a surfactant containing a metallocene group.

The surface was then coated with PVK which had been dissolved in a solvent by an isochronous pulling method. The coating film had a thickness of 20 µm after drying and was used as a CTL.

The electro-photographic characteristics of the thus-produced electro-photographic photo-receptor was measured by a dynamic system by using an electrostatic copying paper testing device SP-428 (produced by Kawaguchi Denki Seisakusho) and a buffer filter of 780 nm.

In the experiment, the surface potential Va of the photo-sensitive layer of the photoreceptor which had been charged for 5 seconds at a charged voltage of -6K was first obtained. The light of a tungsten lamp was then projected on the photo-sensitive layer so that the illumination on the surface thereof was 35 lux and the exposure E1/2 ($erg/cm^2$) which was required to attenuate the surface potential Va to 1/2 and the surface potential Vb after the photo-sensitive layer had been irradiated at an exposure of 15 $erg/cm^2$ were obtained.

The measurement was repeated 200 times,and the results of the first and 200th measurements are shown in the following Table.

| | First | 200th |
|---|---|---|
| Va (v) | -1250 | -1280 |
| E12 $erg/cm^2$ | 3.5 | 3.6 |
| Vb (v) | 0 | 0 |

As is clear from the above Table, the electro-photographic photo-receptor in accordance with the present invention has a sufficient charge retaining force, a high sensitivity, and a small residual potential. In addition, good characteristics are maintained even after repetitive use. That is, the present invention can provide an electro-photographic photo-receptor having excellent characteristics.

Example 24.

The same aluminium drum as in Example 23 was immersed in a solution in which a bisazo pigment was solubilized and a bisazo pigment thin film of about 0.3 µm thick was formed on the surface of the aluminium drum as the photo-sensitive layer (CGL) in the same way as in

Example 23.

Triphenyl amine and polycarbonate were dissolved in 1,2-dichloroethane and the solution was applied to the CGL so as to form a CTL having a thickness of 20 µm after drying.

The photo-sensitive efficiency of the thus-produced photo-receptor was evaluated in the same way as in Example 23. The results are shown in the following table.

| | First | 200th |
|---|---|---|
| Va (v) | -900 | -890 |
| E1/2 $erg/cm^2$ | 3.8 | 3.9 |
| Vb (v) | 0 | 0 |

As is clear from the above table, the electro-photographic photo-receptor in accordance with the present invention has a sufficient charge retaining force, a high sensitivity, and a small residual potential. In addition, good characteristics are maintained even after repetitive use. That is, the present invention can provide an electro-photographic photo-receptor having excellent characteristics.

Example 25.

A CGL was formed to a thickness of 0.25 µm by electrolysis in the same way as in Example 23 by

using a perylene pigment. A CTL of about 20 µm thick was formed by using PVK in the same way as in Example 23.

The results are shown in the following table.

| | First | 200th |
|---|---|---|
| Va (v) | -1100 | -1150 |
| E1/2 erg/cm$^2$ | 3.7 | 3.0 |
| Vb (v) | 0 | 0 |

As is clear from the above table, the electro-photographic photo-receptor in accordance with the present invention has a sufficient charge retaining force, a high sensitivity, and a small residual potential. In addition, good characteristics are maintained even after repetitive use. That is, the present invention can provide an electro-photographic photo-receptor having excellent characteristics.

In Examples 23 to 25, when the sensitivity was measured at as low an initial potential as 600 V, a sufficient value was obtained in each case.

As described above, since a uniform high-density and high-purity CGL film is formed according to the present invention, it is possible to produce a photo-receptor having good characteristics. Furthermore, the present invention enables high productivity and, hence, production of a photo-receptor at a low cost.

Example 26

Figure 10 shows an example of non-linear characteristics of a non-linear switching element. Namely, such a characteristic is preferable for the non-linear switching element.

A film 72 of indium tin oxide (ITO), which is an oxide conductive material, was formed on a glass substrate 71 to a thickness of 1000 Angstrom. On the ITO film 72, a film 73 of photo-sensitive epoxy acrylate, which is an insulating material allowing film formation by patterning, was formed to a thickness of 1 µm, and minute holes of 15 x 15 µm were formed to expose the ITO film 2 (Figure 11(a)). The insulating material which allows film formation by patterning is not restricted to epoxy acrylate.

Electrolysis was carried out in an electrolytic solution in which metal-free phthalocyanine was dispersed in a colloidal state while using the glass substrate 71 as an anode and a platinum electrode as a cathode.

The electrolytic solution had the following composition:

| | |
|---|---|
| Metal-free phthalocyanine | 5 g/l |
| Surfactant charged by electrolysis Ferrocenyl-PEG (produced by Dojin Kagaku) | 1 mM |
| Supporting salt (LiBr) | 0.05 M |

Metal-free phthalocyanine was dispersed in the electrolytic solution in a colloidal state by an ultrasonic homogeniser and the supernatant was used.

The electrolysis was carried out at a constant voltage of + 0.4 V (VS. S.C.E.) for 10 minutes, whereby a metal-free phthalocyanine film 74 of 3000 Angstrom thick was obtained at the minute hole portions (15 x 15 µm) at which the ITO film 72 was exposed (Figure 11(b)).

After, this film 74 was dried at 150°C for 15 minutes, an ITO film 75 was formed on the phthalocyanine film to a thickness of 2000 Angstrom by sputtering (Figure 11 (c)).

Thus, an element having a thin-film structure of ITO - metal-free phthalocyanine - ITO was obtained.

When a voltage was applied between the ITO film 72 as the positive electrode and the ITO film 75 as the negative electrode in Figure 11(c) while gradually raising the voltage, the non-linear characteristic represented by the curve 71 shown in Figure 12 was obtained.

When the positive electrode 72 and the negative electrode 75 in Figure 11(c) were reversed and a voltage was applied while gradually raising the voltage,the non-linear characteristic represented by the curve 72 shown in Figure 12 was obtained. The non-linear characteristic 82 was almost similar to the non-linear characteristic 81. In other words, this element exhibits almost the same non-linear characteristic even if the polarities of the voltage applied are different. That is, a bi-directional non-linear characteristic was obtained.

Example 27.

Metal-free octacyanophthalocyanine was used as an insulating material. Almost the same bi-directional non-linear characteristic as in Example 26 was obtained.

As described above, according to the present invention, a non-linear switching element having the same characteristics as a conventional MIM (Metal Insulator Metal) element can have a larger area which facilitates patterning and it is possible to obtain a chemically stable phthalocyanine film by a wet process. Thus, the present invention not only contributes to the enhancement of the performance per cost but also brings about a great effect on the manufacture of a large-sized active matrix colour liquid crystal panel which will be put to practical use in the near future.

## Claims

1. A thin film device produced by electrolysis in a solution characterised by containing an organic material, an inorganic material or a material being a mixture thereof which material is sparingly soluble or insoluble in water and a surfactant for solubilising said organic material, inorganic material or mixture thereof.

2. A thin film device as claimed in claim 1 characterised in that said organic material is an organic pigment.

3. A thin film device as claimed in claim 2 characterised in that said organic pigment is selected from the group mainly consisting of phthalocyanine pigment, anthraquinone pigment, thioindigo pigment, perylene pigment, quinacridone pigment, dioxazine pigment, isoindolinone pigment, quinophthalone pigment, perinone pigment, nitro pigment, nitroso pigment, azo complex salt pigment, condensed azo pigment, benzoimidazolone pigment, metal complex pigment, aniline black, daylight fluorescent pigment and diketopyrrolopyrrole pigment.

4. A thin film device as claimed in any preceding claim characterised in that said inorganic material is a hydrophilic substance with the surface nature thereof converted into a hydrophobic nature.

5. A thin film device as claimed in any preceding claim characterised in that said surfactant has a metallocene group represented by the following general formula as a hydrophobic end group:
$[M(C_2H_5)_2]$
wherein M represents Cr, Ti, Fe, V, Co, Ni, Ru, Is, Pd or the like.

6. A thin film device as claimed in any preceding claim characterised in that said organic material or inorganic material is particulate having a primary particle diameter of 0.005 to 0.5 $\mu$m.

7. A thin film device as claimed in any preceding claim characterised in that said thin film device contains a dopant for providing electrical conductivity.

8. A thin film device as claimed in claim 7 characterised in that said dopant is a halogen.

9. A thin film device as claimed in claim 8 characterised in that said halogen is doped by dissolving a halogen or a halogen compound in said aqueous micelle solution so as to deposit said halogen together with a film material.

10. A thin film device as claimed in claim 8 characterised in that said halogen is doped by immersing said thin film device in a solution containing a halogen or a halogen compound after the formation of said thin film device so as to effect electrolysis.

11. A thin film device as claimed in any preceding claim characterised in that said thin film device is used for a colour filter.

12. A thin film device as claimed in claim 11 characterised in that each coloured layer of said colour filter is composed of a mixture of at least two types of organic pigments.

13. A thin film device as claimed in claim 11 or 12 characterised in that an insulating film or a high-resistance film is formed on a part of the unselected electrode pattern in advance when electrolysis is carried out by selectively establishing electric conduction on a specific electrode pattern formed on a substrate.

14. A thin film device as claimed in any of claims 11 to 13 characterised in that a light-shielding film is formed between the transparent electrode patterns formed on a transparent substrate.

15. A thin film device as claimed in claim 14 characterised in that said light-shielding film is formed by a dyeing method using photo-lithography.

16. A thin film device as claimed in claim 14 characterised in that said light-shielding film is a photo-setting type photo-sensitive resin containing a pigment.

17. A thin film device as claimed in claim 14 characterised in that said light-shielding film is formed by a method comprising the steps of plating a metal film on the transparent electrode formed into a predetermined pattern on a transparent substrate in advance, coating said metal film with a negative resist containing a light-shielding material, exposing the opposite side of said transparent substrate to the coated side to UV light and developing said transparent substrate so as to form said light-shielding film between said transparent electrode patterns.

18. A thin film device as claimed in claim 17 characterised in that said light-shielding pattern is formed by printing between the patterns with coloured layers formed thereon or on the opposing substrate at the portions facing the gaps between said patterns with said coloured layers formed thereon.

19. A thin film device as claimed in any of claims 1 to 10 characterised in that said thin film device is used for an optical recording medium.

20. A thin film device as claimed in claim 19 characterised in that a photo-chromic film is formed.

21. A thin film device as claimed in claim 19 or 20 characterised in that a thin film of a compound having a photo-chemical hole burning effect is formed.

22. A thin film device as claimed in any of claims 1 to 10 characterised in that said thin film device is used for an electro-photographic photo-receptor.

23. A thin film device as claimed in any of claims 1 to 10 characterised in that said thin film device is used as a carrier generating layer of said electro-photographic photo-receptor.

24. A method of manufacturing a thin film device comprising the steps of solubilising an organic material, an inorganic material or a mixture thereof which is sparingly soluble or insoluble in water in an aqueous micelle solution of a surfactant which is charged by electrolysis, and carrying out electrolysis in said aqueous micelle solution so as to destroy said micelle and deposit the solubilized material on an electrode, thereby forming a thin film.

25. A non-linear switching element having a thin-film laminate structure comprising a conductive material, an organic insulating thin film and a conductive material, wherein said organic insulating thin film is formed by a method characterised by comprising the steps of solubilising an organic material, an inorganic material or a mixture thereof which is sparingly soluble or insoluble in water in an aqueous micelle solution of a surfactant which is charged by electrolysis, and carrying out electrolysis in said aqueous micelle solution so as to destroy said micelle and deposit the solubilized material on an electrode.

26. A non-linear switching element as claimed in claim 25 characterised in that said non-linear switching element has a bi-directional non-linear characteristic.

27. A non-linear switching element as claimed in claim 25 or 26 characterised in that said organic insulating thin film is composed of a phthalocyanine material.

Neu eingereicht / Newly filed
Nouvellement déposé

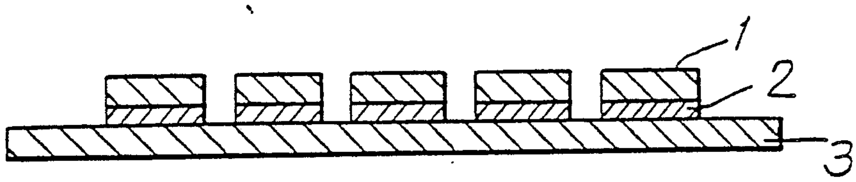


FIG. 1

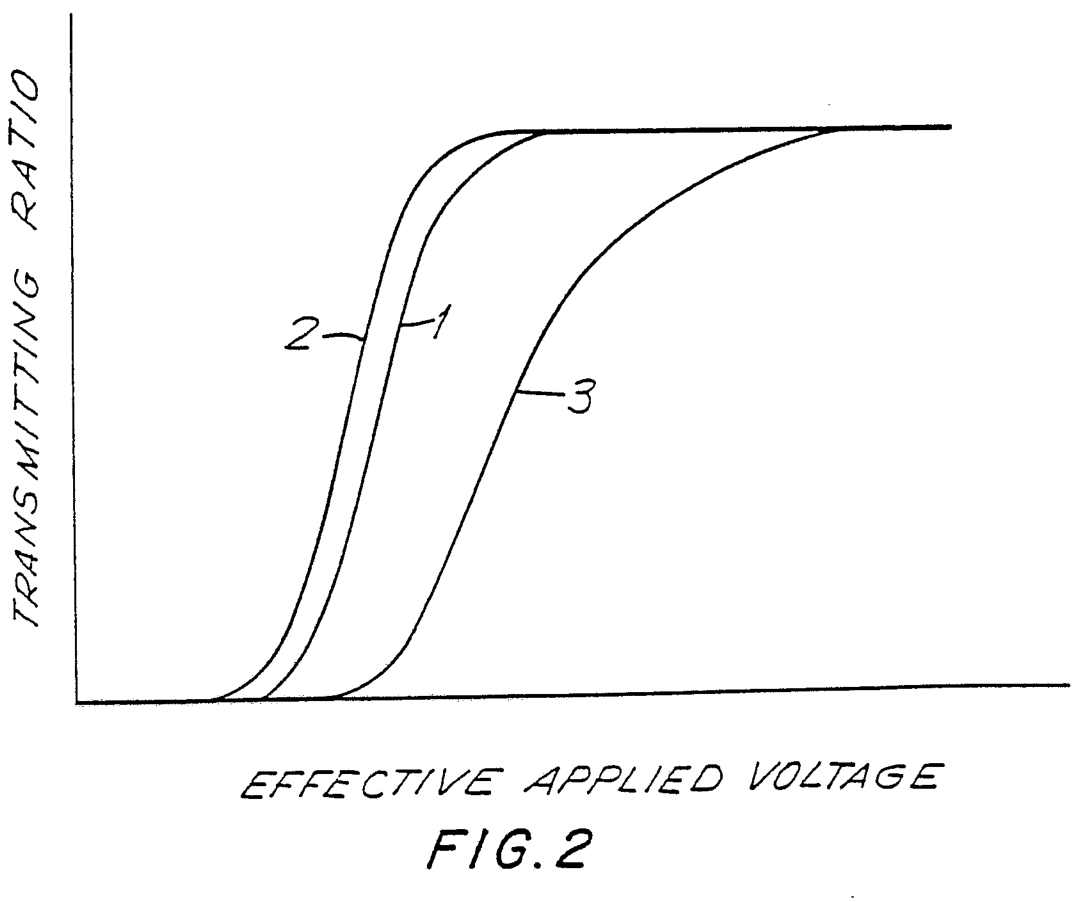


FIG. 2

Neu eingereicht / Newly filed
Nouvellement déposé

FIG. 3

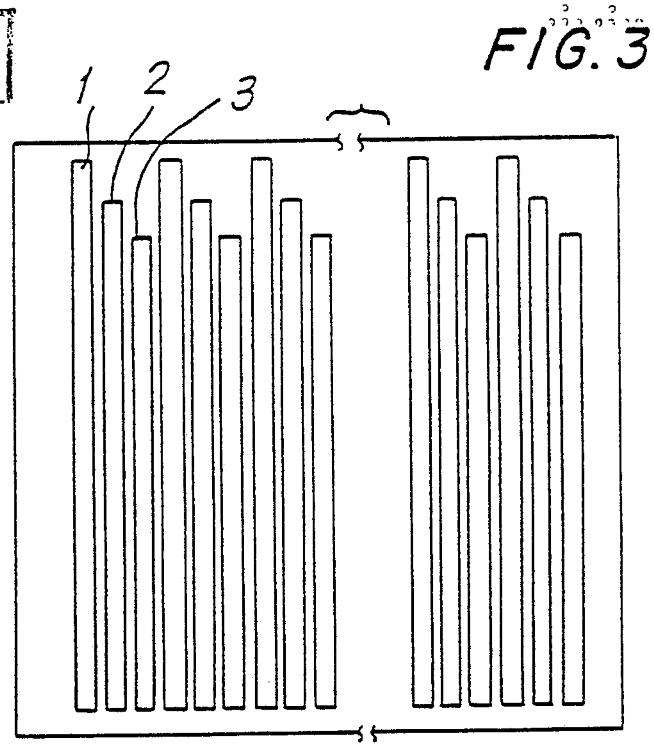


FIG. 4

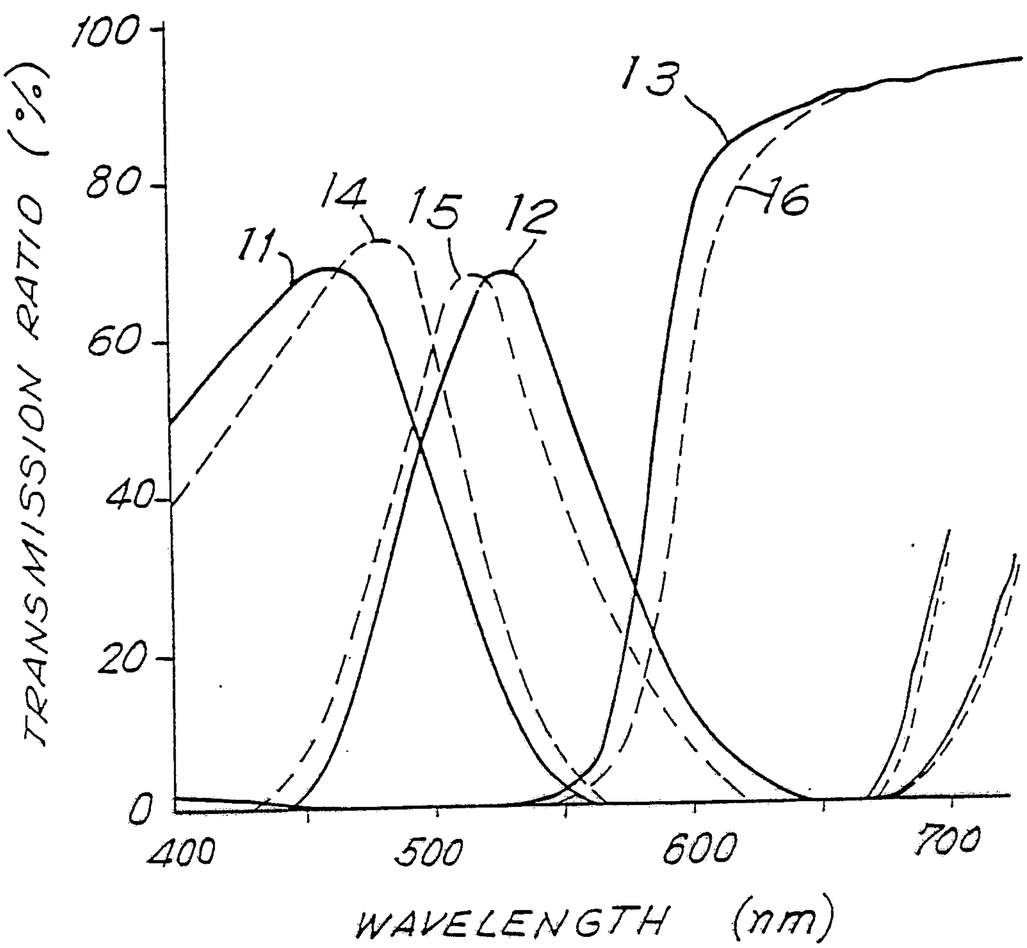

Neu eingereicht / Newly filed
Nouvellement déposé

FIG. 5

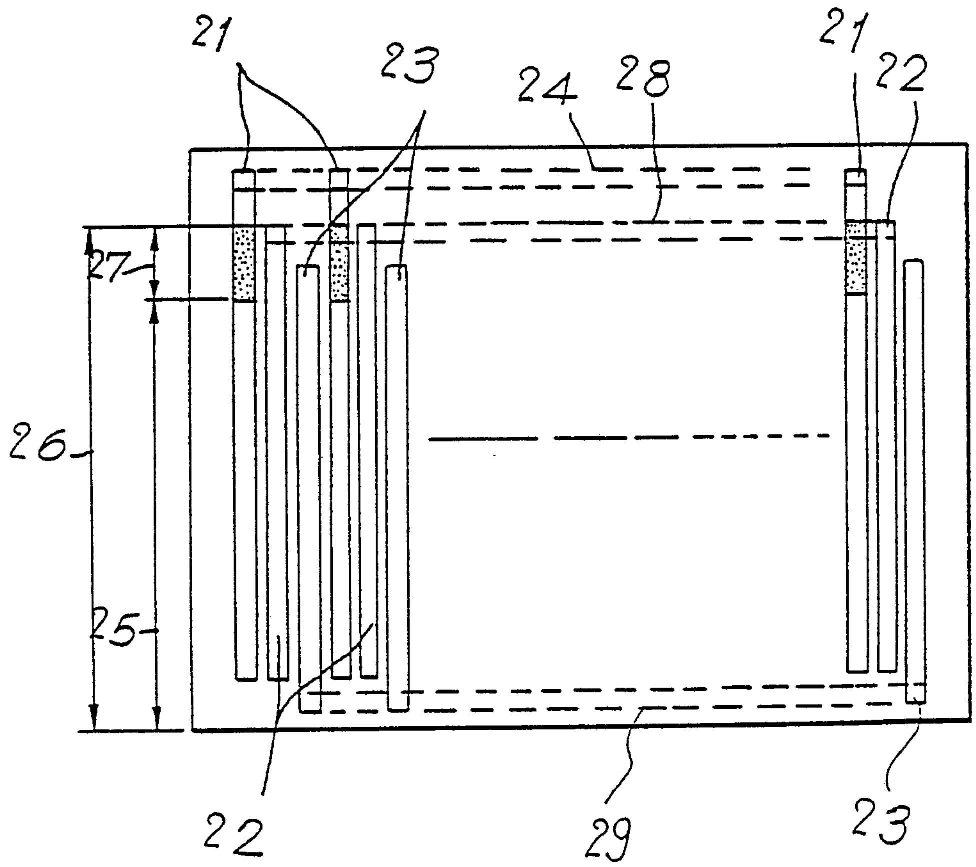

Neu eingereicht / Newly filed
Nouvellement déposé

FIG. 6

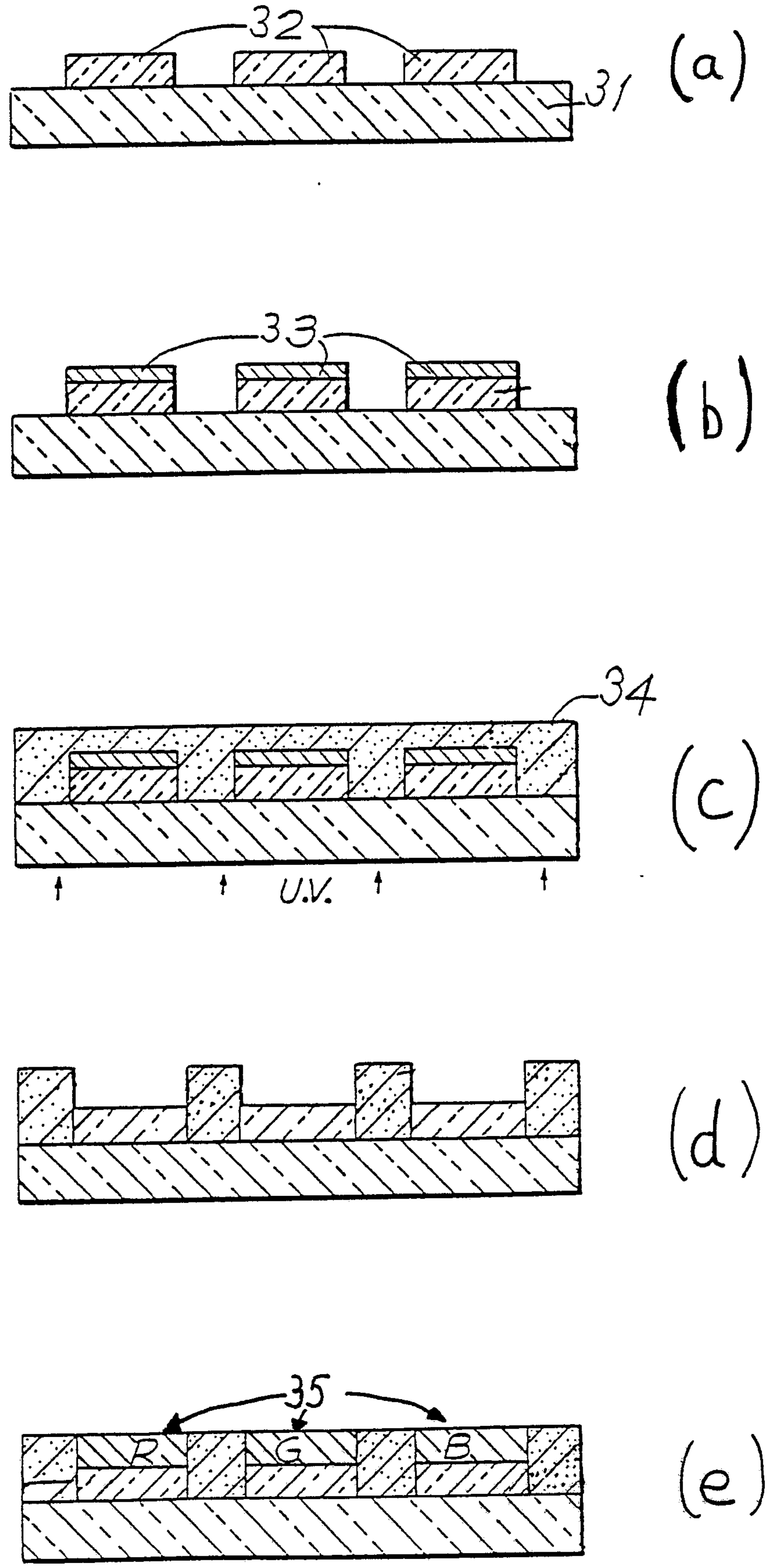

Neu eingereicht / Newly filed
Nouvellement déposé

FIG. 7

(a)

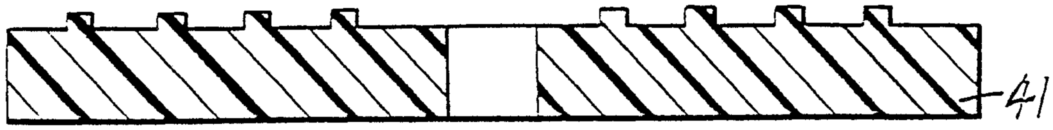


(b)

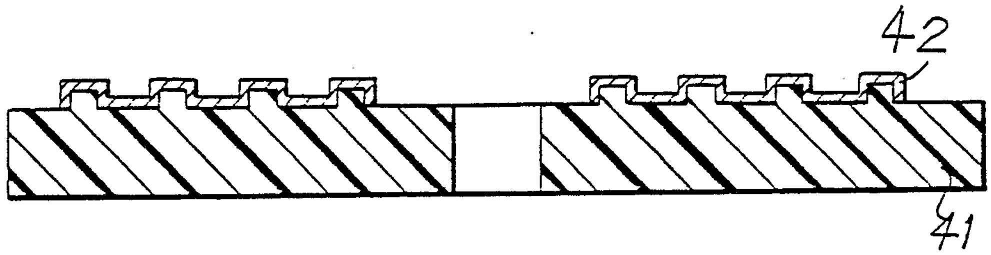


(c)

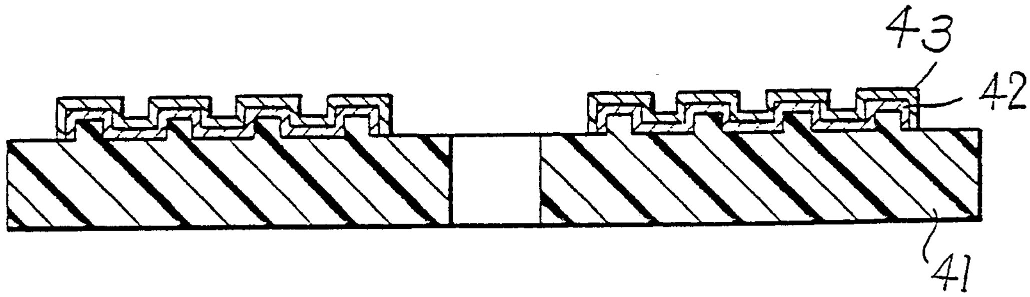


(d)

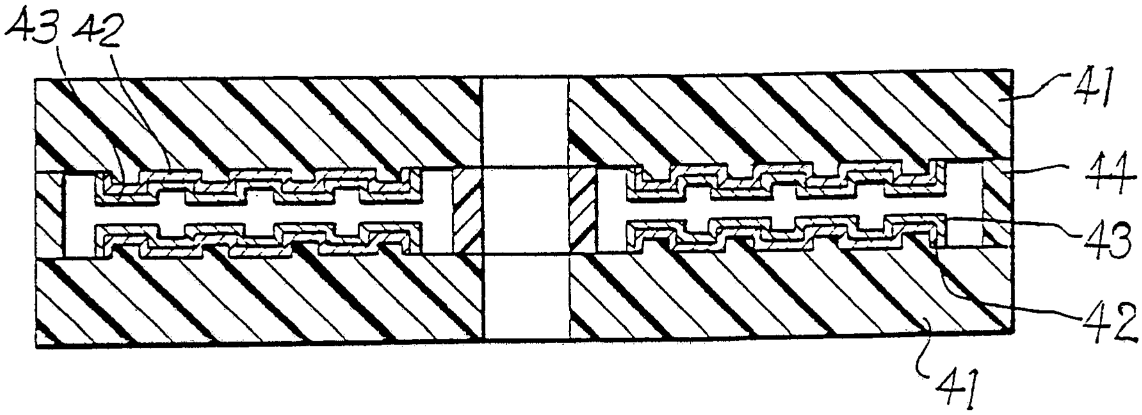

Neu eingereicht / Newly filed
Nouvellement déposé

FIG. 8

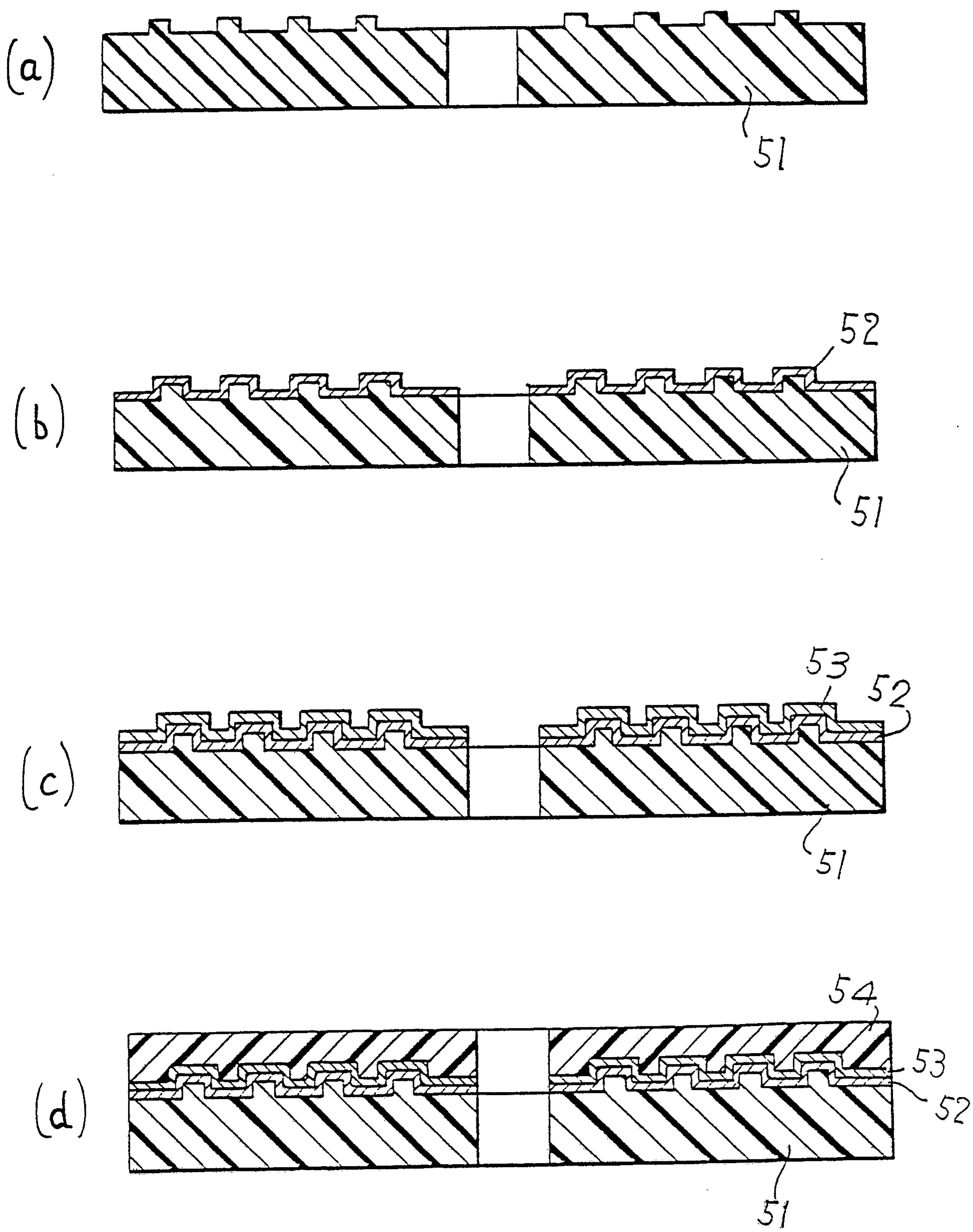

Neu eingereicht / Newly filed
Nouvellement déposé

F/G. 10

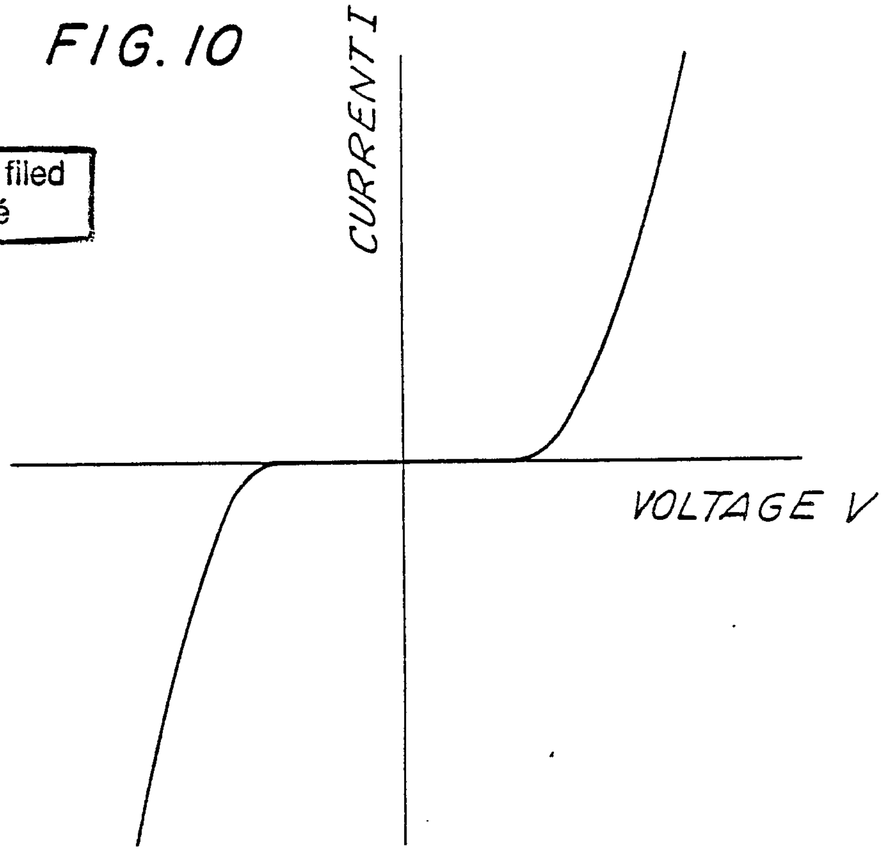


FIG 11

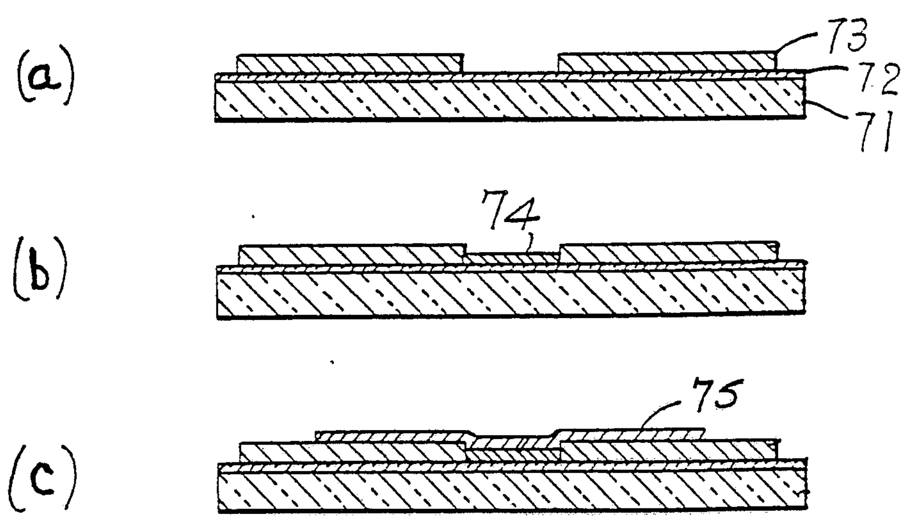

Neu eingereicht / Newly filed
Nouvellement déposé

FIG. 9

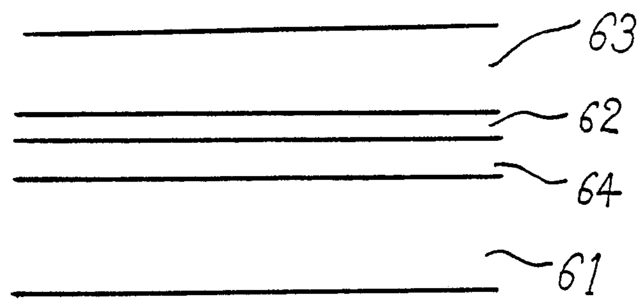


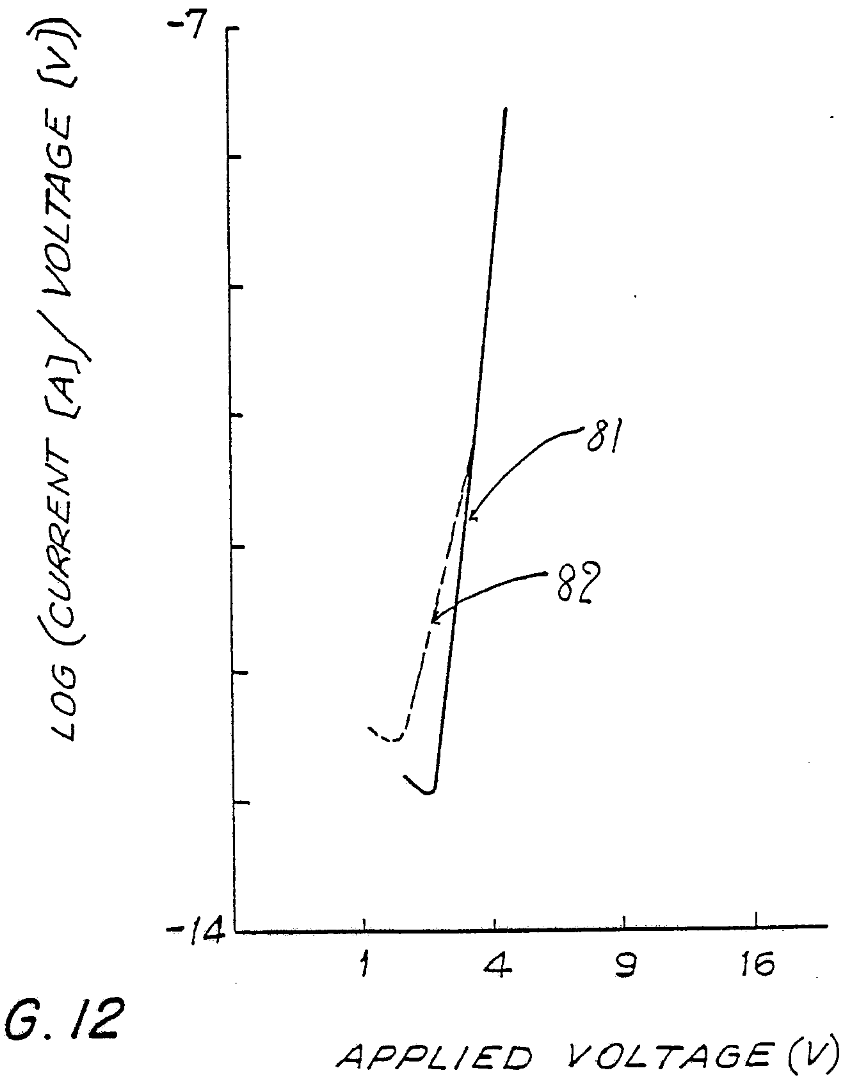


FIG. 12